# EUROPÄISCHE PATENTSCHRIFT

(11) **EP 3 642 878 B1**
(45) Veröffentlichungstag und Bekanntmachung des Hinweises auf die Patenterteilung: **21.04.2021**
(21) Anmeldenummer: 18733813.2
(22) Anmeldetag: 14.06.2018
(51) Int. Cl.: H01L 27/15, H01L 33/08, H01L 33/18

(54) **HALBLEITERDISPLAY**
SEMICONDUCTOR DISPLAY
DISPOSITIF D'AFFICHAGE À SEMI-CONDUCTEUR

(30) Priorität: 21.06.2017 DE 102017113745
(43) Veröffentlichungstag der Anmeldung: 29.04.2020
(73) Patentinhaber: OSRAM OLED GmbH, 93055 Regensburg (DE)
(72) Erfinder: HERRMANN, Siegfried, 94362 Neukirchen (DE)
(74) Vertreter: OSRAM OLED GmbH
(86) Internationale Anmeldenummer: PCT/EP2018/065866
(87) Internationale Veröffentlichungsnummer: WO 2018/234160

(56) Entgegenhaltungen:
- DE-A1-102012 109 460
- FR-A1- 3 031 238
- US-A1- 2015 263 066

## Beschreibung

Es wird ein Halbleiterdisplay angegeben.

Eine zu lösende Aufgabe liegt darin, ein Halbleiterdisplay anzugeben, das über eine hohe Auflösung verfügt und das effizient fertigbar ist.

Diese Aufgabe wird unter anderem durch ein Halbleiterdisplay mit den Merkmalen des unabhängigen Patentanspruchs 1 gelöst. Bevorzugte Weiterbildungen sind Gegenstand der abhängigen Ansprüche.

Gemäß zumindest einer Ausführungsform dient das Halbleiterdisplay zur Darstellung von Bildern, insbesondere von beweglichen Bildern. Bevorzugt ist das Halbleiterdisplay zur farbigen Darstellung eingerichtet. Dazu weist das Halbleiterdisplay eine Vielzahl von Bildpunkten, auch als Pixel bezeichnet, auf. Insbesondere sind einzelne Bildpunkte zur verschiedenfarbigen Abstrahlung von Licht eingerichtet. Das verschiedenfarbige Licht, das von einzelnen Bildpunkten emittiert wird, setzt sich bevorzugt aus blauem, rotem und grünem Licht zusammen.

Gemäß der Erfindung umfasst das Halbleiterdisplay eine Vielzahl von Halbleitersäulen. Insbesondere sind die Bildpunkte durch die Halbleitersäulen gebildet. Dabei umfasst jeder Bildpunkt bevorzugt mehrere, eventuell auch nur eine, der Halbleitersäulen. Die Halbleitersäulen können einzeln oder in kleinen Gruppen zusammengenommen elektrisch unabhängig voneinander ansteuerbar sein. Kleine Gruppe bedeutet höchstens 25 oder 16 oder 10 oder 4 der Halbleitersäulen.

Gemäß der Erfindung umfasst das Halbleiterbauteil erste und zweite elektrische Kontaktleisten. Bei den Kontaktleisten handelt es sich bevorzugt um Spaltenkontakte und um Zeilenkontakte. Über die Kontaktleisten sind die Halbleitersäulen elektrisch ansteuerbar.

Gemäß der Erfindung umfassen die Halbleitersäulen je einen Halbleiterkern eines ersten Leitfähigkeitstyps. Insbesondere ist der Halbleiterkern jeweils aus n-dotierten Halbleitermaterialien.

Gemäß der Erfindung umfassen die Halbleitersäulen je eine Halbleiterhülle aus einem Halbleitermaterial, das einen zweiten, vom ersten verschiedenen Leitfähigkeitstyp aufweist. Insbesondere sind die Halbleiterhüllen aus einem p-leitenden Halbleitermaterial.

Gemäß der Erfindung umfassen die Halbleitersäulen je eine aktive Schicht. Die aktive Schicht, beispielsweise eine Einfachquantentopfstruktur oder eine Multiquantentopfstruktur, befindet sich bevorzugt durchgehend zwischen dem jeweiligen Halbleiterkern und der zugehörigen Halbleiterhülle. Die aktive Schicht ist zur Strahlungserzeugung, insbesondere zur Erzeugung von sichtbarem Licht wie blauem Licht, eingerichtet. Es ist möglich, dass alle Halbleitersäulen und damit alle aktiven Schichten im Rahmen der Herstellungstoleranzen baugleich gestaltet sind, sodass alle Halbleitersäulen eine Primärstrahlung der gleichen Farbe emittieren. Alternativ weisen verschiedene Halbleitersäulen voneinander verschiedene aktive Schichten zur Erzeugung von Licht unterschiedlicher Farben und/oder Wellenlängen auf.

Gemäß der Erfindung weisen die Halbleitersäulen je eine Bestromungshülle auf. Die Bestromungshülle ist zur Bestromung der jeweiligen zugeordneten Halbleiterhülle eingerichtet. Die Bestromungshüllen sind bevorzugt aus einem transparenten leitfähigen Oxid, kurz TCO, wie Indiumzinnoxid oder aus einem oder mehreren Metallen wie Silber.

Gemäß der Erfindung umfasst das Halbleiterdisplay eine Vielzahl von Halbleitersäulen sowie erste und zweite elektrische Kontaktleisten. Die Halbleitersäulen umfassen je einen Halbleiterkern eines ersten Leitfähigkeitstyps und eine Halbleiterhülle eines vom ersten verschiedenen, zweien Leitfähigkeitstyps sowie eine dazwischenliegende aktive Schicht zur Strahlungserzeugung. Die Halbleitersäulen umfassen je eine Bestromungshülle, die zur Bestromung auf die jeweilige Halbleiterhülle aufgebracht ist. Die Halbleitersäulen sind einzeln oder in kleinen Gruppen über die ersten und zweiten elektrischen Kontaktleisten elektrisch unabhängig voneinander ansteuerbar.

Mit dem hier beschriebenen Display sind einzelne Bildpunkte mit kleinen Abmessungen herstellbar und zu einem Modul kombinierbar und/oder in dem Display verwendbar. Die Verkleinerung von möglichen Abmessungen für die einzelnen Bildpunkte wird durch die Verwendung der elektrisch einzeln oder in kleinen Gruppen adressierbaren Halbleitersäulen ermöglicht. Dabei weisen die einzelnen Halbleitersäulen bevorzugt in Draufsicht gesehen Flächen im Bereich um 1 µm² auf.

Somit lassen sich mit dem hier beschriebenen Verfahren bei dem hier beschriebenen Display beispielsweise mindestens 1000 x 1000 = 10⁶ Halbleitersäulen pro mm² wachsen. Die Halbleitersäulen können in dieser Dichte in dem Display vorliegen oder hinsichtlich lateraler Abstände expandiert sein, sodass im fertigen Display größere Abstände zwischen einzelnen Bildpunkten und Halbleitersäulen vorliegen. Dabei weisen die Halbleitersäulen bevorzugt ähnliche Höhen und Durchmesser auf. Mit anderen Worten liegt ein Aspektverhältnis der Halbleitersäulen aus einer Höhe und einem mittleren Durchmesser bevorzugt in der Größenordnung von 1, kann aber auch größer sein.

Alternative Möglichkeiten aus dem Stand der Technik zur Herstellung von LED-Displays liegen darin, einzelne große Halbleiterchips zu fertigen und diese lithografisch zu strukturieren. Durch die anders als bei dem hier beschriebenen Display dann lediglich zweidimensional gestaltete aktive Zone ist jedoch eine Leuchtdichte pro Flächeneinheit begrenzt. Ferner steigen die Schwierigkeiten beim Wachsen von großflächigen, zusammenhängenden Halbleiterschichtenfolgen, anders als bei den hier strukturierten Halbleitersäulen. Bei herkömmlichen zweidimensionalen Halbleiterschichten ist eine Größe einzelner Bildpunkte auf eine Kantenlänge von ungefähr 10 µm und damit eine Fläche von ungefähr 100 µm² beschränkt, um ausreichende Helligkeiten zu erreichen. Demgegenüber lässt sich mit dem hier beschriebenen Display eine Erhöhung der Dichte von einzeln ansprechbaren Halbleitersäulen und/oder Bildpunkten zumindest an einem Aufwachssubstrat um einen Faktor 100 erzielen.

Dokumente US 2015/263066 A1, FR 3 031 238 A1 und DE 10 2012 109460 A1 offenbaren Halbleiterdisplays die Halbleitersäulen aufweisen.

Gemäß der Erfindung umfasst das Halbleiterdisplay einen oder mehrere Vergusskörper. Der mindestens eine Vergusskörper ist für die erzeugte Strahlung undurchlässig.

Gemäß der Erfindung basieren die Halbleitersäulen auf einem Nitrid-Verbindungshalbleitermaterial wie AlₙIn₁₋ₙ₋ₘGaₘN Bevorzugt gilt dabei für zumindest eine Schicht oder für alle Schichten der Halbleiterschichtenfolge 0 < n ≤ 0,8, 0,4 ≤ m < 1 und n + m ≤ 0,95 . Dabei kann die Halbleiterschichtenfolge Dotierstoffe sowie zusätzliche Bestandteile aufweisen. Der Einfachheit halber sind jedoch nur die wesentlichen Bestandteile des Kristallgitters der Halbleiterschichtenfolge, also Al, As, Ga, In, N oder P, angegeben, auch wenn diese teilweise durch geringe Mengen weiterer Stoffe ersetzt und/oder ergänzt sein können.

Gemäß der Erfindung umfasst das Halbleiterdisplay mindestens 10⁴ oder 10⁵ oder 10⁶ oder 10⁷ der Halbleitersäulen. Dabei können beispielsweise drei oder vier der Halbleitersäulen zu einem Bildpunkt zusammengeschaltet sein. Eine Flächendichte der Halbleitersäulen an einem Aufwachssubstrat und/oder in dem fertigen Display liegt beispielsweise bei mindestens 10² oder 10³ oder 10⁴ oder 10⁶ pro mm².

Gemäß der Erfindung befinden sich die Halbleitersäulen in Ausnehmungen des Vergusskörpers. Die Ausnehmungen können formgleich zu den Halbleitersäulen gestaltet sein, sodass die Ausnehmungen vollständig oder im Wesentlichen vollständig von den Halbleitersäulen ausgefüllt sind, beispielsweise zu mindestens 50 % oder 70 % oder 85 %. Insbesondere sind die Ausnehmungen formschlüssig und vollständig von den Halbleitersäulen samt den zugehörigen Bestromungshüllen ausgefüllt. Dabei können die Bestromungshüllen eine konstante Schichtdicke aufweisen. Alternativ weisen die Ausnehmungen etwa im Querschnitt gesehen eine von den Halbleitersäulen verschiedene Grundform auf, sodass die Ausnehmungen nur teilweise von den Halbleitersäulen ausgefüllt sind, beispielsweise zu höchstens 30 % oder 50 % oder 70 %.

Gemäß zumindest einer Ausführungsform liegt ein mittlerer Durchmesser der Halbleitersäulen bei mindestens 10 nm oder 40 nm oder 250 nm. Alternativ oder zusätzlich weisen die Halbleitersäulen einen mittlerer Durchmesser von höchstens 10 µm oder 5 µm oder 2 µm auf. Bevorzugt liegt der mittlere Durchmesser zwischen einschließlich 0,5 µm und 2 µm.

Gemäß zumindest einer Ausführungsform liegt ein Verhältnis aus einer mittleren Höhe der Halbleitersäulen und dem mittleren Durchmesser bei mindestens 0,2 oder 0,5 oder 1. Alternativ oder zusätzlich liegt dieses Verhältnis bei höchstens 10 oder 6 oder 3 oder 1,5. Alternativ ist es möglich, dass dieses Verhältnis vergleichsweise groß ist, beispielsweise bei mindestens 3 oder 5 oder 7, insbesondere zwischen einschließlich 5 und 10.

Gemäß zumindest einer Ausführungsform sind die Halbleitersäulen hexagonal gestaltet. Das heißt, die Halbleitersäulen sind insbesondere durch regelmäßige Sechsecksäulen und/oder durch hexagonale Pyramiden gebildet.

Gemäß zumindest einer Ausführungsform sind die Halbleitersäulen von einem Basisbereich her gewachsen. Dem Basisbereich liegt eine Spitze gegenüber. Die Spitze ist bevorzugt pyramidal, insbesondere in Form einer regelmäßigen Sechseckpyramide. Alternativ ist es möglich, dass die Spitze abgerundet ist oder flach ist.

Gemäß zumindest einer Ausführungsform erfolgt eine Bestromung der Halbleitersäulen über die Basisbereiche. Insbesondere bilden die Basisbereiche eine n-Seite der Halbleitersäulen. An den Basisbereichen kann sich eine Halbeiterkontaktschicht und/oder eine TCO-Kontaktschicht zur Bestromung der Halbleitersäulen befinden.

Gemäß zumindest einer Ausführungsform erstreckt sich die aktive Schicht je durchgehend über Seitenflächen und/oder die Spitze der Halbleitersäulen. Alternativ kann die aktive Schicht auf bestimmte Teilbereiche der Seitenflächen und/oder der Spitze der betreffenden Halbleitersäule begrenzt sein.

Gemäß zumindest einer Ausführungsform verlaufen die ersten Kontaktleisten in Draufsicht gesehen senkrecht oder näherungsweise senkrecht zu den zweiten Kontaktleisten. Somit lassen sich Spaltenkontakte und Zeilenkontakte realisieren.

Gemäß zumindest einer Ausführungsform verlässt die im Betrieb in den Halbleitersäulen erzeugte Strahlung diese nur über den Basisbereich und damit in Richtung weg von den Spitzen. Dabei ist eine Hauptemissionsrichtung bevorzugt parallel zu einer Längsachse der Halbleitersäulen, verlaufend von dem jeweiligen Basisbereich zur Spitze, orientiert. Alternativ ist es möglich, dass die Strahlung in Richtung weg von dem Basisbereich insbesondere nur über die Spitze emittiert wird. weiterhin kann die erzeugte Strahlung zum Teil auch an Seitenflächen der Halbleitersäulen emittiert werden.

Gemäß zumindest einer Ausführungsform überragen die Halbleitersäulen den Vergusskörper an einer oder an zwei einander gegenüberliegenden Hauptseiten des Vergusskörpers. Das heißt, eine Dicke des Vergusskörpers kann kleiner sein als eine Höhe der Halbleitersäulen. Damit befinden sich die Halbleitersäulen entlang der Längsachse nur zum Teil in dem Vergusskörper. Alternativ kann der Vergusskörper dicker gestaltet sein, sodass die Halbleitersäulen vollständig innerhalb des Vergusskörpers liegen, entlang der Längsachse gesehen, oder dass die Halbleitersäulen den Vergusskörper nur an einer Hauptseite überragen.

Gemäß zumindest einer Ausführungsform verlaufen die ersten Kontaktleisten entlang von Zeilen an den Spitzen der Halbleitersäulen. Somit können die Spitzen der Halbleitersäulen über die ersten Kontaktleisten elektrisch kontaktiert sein. Dabei ist es möglich, dass die Kontaktleisten auf den Bereich der Spitzen beschränkt sind und damit beabstandet zu den Basisbereichen verlaufen. Die ersten Kontaktleisten können im Wesentlichen senkrecht zu den Längsachsen der Halbleitersäulen orientiert sein.

Gemäß zumindest einer Ausführungsform umfassen die zweiten Kontaktleisten eine Halbleiterschicht, insbesondere eine n-leitende Halbleiterschicht. Bevorzugt sind die Halbleitersäulen aus dieser Halbleiterschicht heraus gewachsen.

Gemäß zumindest einer Ausführungsform ist die Halbleiterschicht der zweiten Kontaktleisten zu Spaltenkontakten strukturiert. Das heißt, in Draufsicht gesehen ist die Halbleiterschicht dann in mehrere Streifen unterteilt. Alternativ kann diese Halbleiterschicht eine ununterbrochene und durchgehende Schicht sein. Beispielsweise weist diese Halbleiterschicht eine Dicke von mindestens 10 nm oder 0,1 µm oder 0,2 µm und/oder von höchstens 2 µm oder 1 µm auf.

Gemäß zumindest einer Ausführungsform ist an einer den Halbleitersäulen abgewandten Seite der Halbleiterschicht mindestens ein Spiegel angebracht. Der mindestens eine Spiegel ist zur Reflexion der im Betrieb erzeugten Strahlung eingerichtet. Der Spiegel kann sich direkt an der Halbleiterschicht befinden oder, bevorzugt, beabstandet zur Halbleiterschicht angeordnet sein. Der Spiegel ist bevorzugt ein metallischer Spiegel oder ein totalreflektierendmetallischer Kombinationsspiegel.

Gemäß zumindest einer Ausführungsform ist an dem mindestens einen Spiegel oder an mindestens einem der Spiegel oder an allen Spiegeln eine elektrische Durchkontaktierung angebracht. Die Durchkontaktierung verläuft bevorzugt in Richtung weg von den Halbleitersäulen. Unter anderem damit ist es möglich, dass alle elektrischen Kontakte zum Anschließen der Halbleitersäulen an einer einzigen Hauptseite des Halbleiterdisplays angebracht sind.

Gemäß zumindest einer Ausführungsform umfasst das Halbleiterdisplay eine oder mehrere Maskenschichten. Die mindestens eine, bevorzugt genau eine Maskenschicht umfasst eine Vielzahl von Öffnungen. Die Halbleitersäulen sind je aus den Öffnungen gewachsen, sodass eine Eins-zu-Eins-Zuordnung zwischen den Öffnungen und den Halbleitersäulen bestehen kann. Dabei weisen die fertig gewachsenen Halbleitersäulen bevorzugt einen größeren Durchmesser auf als die Öffnungen, sodass die Öffnungen jeweils vollständig von den Halbleitersäulen überdeckt sein können, in Draufsicht gesehen.

Gemäß zumindest einer Ausführungsform ist die Maskenschicht aus einem anorganischen Material wie einem Nitrid, insbesondere Siliziumnitrid, oder einem Oxid wie Siliziumdioxid. Bei der Maskenschicht handelt es sich bevorzugt um eine zusammenhängende Schicht, sodass alle Öffnungen in einer einzigen Schicht geformt sind. Die Maskenschicht ist insbesondere eine dünne Schicht, beispielsweise mit einer Dicke höchstens 200 nm oder 50 nm oder 10 nm oder 3 nm. Insbesondere liegt die Dicke der Maskenschicht neben den Öffnungen bei mindestens 0,1 nm oder 1 nm oder 5 nm oder 20 nm.

Gemäß zumindest einer Ausführungsform umfassen die zweiten Kontaktleisten mindestens eine transparente leitfähige Schicht. Diese leitfähige Schicht befindet sich bevorzugt an den Basisbereichen oder an der insbesondere n-leitenden Halbleiterschicht der zweiten Kontaktleisten. Die transparente leitfähige Schicht kann sich zu einzelnen Streifen strukturiert entlang der Spalten erstrecken und Spaltenkontakte bilden.

Gemäß zumindest einer Ausführungsform sind die ersten Kontaktleisten für die zu erzeugende Strahlung reflektierend gestaltet. Dabei sind insbesondere die Bestromungshüllen von den ersten Kontaktleisten umfasst. In diesem Fall sind die Bestromungshüllen bevorzugt aus einem reflektierenden Metall wie Silber geformt. Es können die Bestromungshüllen sowohl Teil der Halbleitersäulen als auch Teil der ersten Kontaktleisten sein.

Gemäß zumindest einer Ausführungsform umfassen die zweiten Kontaktleisten zusätzlich mindestens eine Stromschiene, etwa eine metallische Stromschiene. Dabei befinden sich die Halbleitersäulen bevorzugt entlang einer Hauptemissionsrichtung je bevorzugt zwischen der elektrisch zugeordneten transparenten leitfähigen Schicht und der zugeordneten Stromschiene. Das heißt, die zweiten Kontaktleisten können entlang der Hauptemissionsrichtung beiderseits der Halbleitersäulen verlaufen.

Gemäß zumindest einer Ausführungsform sind die Stromschienen frei zugänglich. Das heißt, das Halbleiterdisplay ist beispielsweise über die Stromschienen elektrisch extern kontaktierbar. Alternativ sind die Stromschienen innerhalb des Halbleiterdisplays verborgen, um elektrische Kurzschlüsse zu vermeiden.

Gemäß zumindest einer Ausführungsform befinden sich die Halbleitersäulen in dem fertigen Halbleiterdisplay noch an dem Aufwachssubstrat. Alternativ wurde das Aufwachssubstrat von den Halbleitersäulen entfernt, sodass das fertige Halbleiterdisplay frei von dem Aufwachssubstrat ist.

Gemäß zumindest einer Ausführungsform sind die ersten und zweiten Kontaktleisten an der gleichen Seite des Aufwachssubstrats angebracht wie die Halbleitersäulen. Dabei können sich auch wesentliche Teile der ersten und zweiten Kontaktleisten an der gleichen Seite der Halbleitersäulen befinden, beispielsweise alle längs der Spalten und/oder der Zeilen verlaufenden Teile und alle elektrischen Kontaktflächen.

Gemäß zumindest einer Ausführungsform umfassen die ersten und/oder zweiten Kontaktleisten elektrische Kontaktflächen zur externen elektrischen Kontaktierung des Halbleiterdisplays. Bevorzugt sind die Kontaktflächen lötbar oder elektrisch leitfähig klebbar gestaltet.

Gemäß zumindest einer Ausführungsform befinden sich die Kontaktflächen in Draufsicht gesehen neben einem Abstrahlfeld des Halbleiterdisplays. In dem Abstrahlfeld sind die Halbleitersäulen angeordnet, insbesondere dicht angeordnet. Damit kann eine kompakte Anordnung der Halbleitersäulen gegeben sein, die durch keine Kontaktflächen unterbrochen ist. Alternativ ist es möglich, dass zumindest einige der Kontaktflächen in Draufsicht gesehen deckungsgleich zu den Halbleitersäulen und/oder dem Abstrahlfeld angeordnet sind und sich beispielsweise an einer nicht zur Lichtemission vorgesehenen Unterseite des Halbleiterdisplays befinden. Gemäß zumindest einer Ausführungsform ist das Halbleiterdisplay oberflächenmontierbar. In diesem Fall liegen bevorzugt alle Kontaktflächen an derselbe Seite der Halbleitersäulen.

Gemäß zumindest einer Ausführungsform weisen die elektrischen Kontaktflächen in Draufsicht gesehen eine größere Breite auf als die jeweils zugehörigen ersten und/oder zweiten Kontaktleisten. Mit anderen Worten sind die Kontaktflächen hinsichtlich der Breite expandiert bezüglich der zugehörigen Kontaktleisten. Eine solche Anordnung der Kontaktflächen wird auch als Fan Out bezeichnet.

Gemäß zumindest einer Ausführungsform erfolgt mittels der Halbleitersäulen mindestens zum Teil eine winkelabhängige Abstrahlung. Dadurch werden raumwinkelabhängige Sehkanäle ermöglicht, etwa für autostereoskopische, dreidimensionale Darstellungen von Bildern oder Filmen.

Die winkelabhängige Abstrahlung ist beispielsweise durch eine Höhenvariation einer Abdeckschichten oder von elektrischen Kontaktierungen der Halbleitersäulen erreichbar. Die Winkelabhängigkeit der Abstrahlung kann auch durch eine periodische Anordnung der Ausnehmungen, in denen sich die Halbleitersäulen befinden, erreicht werden.

Weiterhin kann die Winkelabhängigkeit der Abstrahlung zum Beispiel durch die Anordnung von Leuchtstoffen erreicht werden. Zum Beispiel befindet sich der Leuchtstoff in verschiedenen Ausnehmungen entweder in der Nähe einer Abstrahlfläche oder an den Seitenflächen der Halbleitersäulen oder es liegen unterschiedliche Füllniveaus der Leuchtstoffe in Bezug auf die Längsachse der Halbleitersäulen vor.

Weiterhin kann die Winkelabhängigkeit durch partielles Abdecken der Halbleitersäulen mit einer lichtundurchlässigen, insbesondere metallischen Schicht wie den Bestromungshüllen erreicht werden, sodass eine Variation der Anordnung der Bestromungshüllen entlang der Längsachsen der Halbleitersäulen gegeben ist. Damit kann zudem eine Variation einer Bestromung, insbesondere eine Teilbestromung, durch partielle Bestromungshüllen erreicht werden, welche insbesondere nur an Teilgebieten der Mantelflächen der Halbleitersäulen angeordnet sind.

Alternativ oder zusätzlich kann eine Deaktivierung von Teilbereichen der Halbleitersäulen etwa durch teilweises rückätzen oder Polieren der Halbleitersäulen erreicht werden. Zudem können die Halbleitersäulen infolge des Transferverfahrens mit ihren Grundflächen und Basisbereichen auf unterschiedlichen Niveaus, etwa relativ zum Träger, angeordnet sein.

Gemäß zumindest einer Ausführungsform liegt eine Anordnung mit einer Lötkugel-Kontaktierung, auch als Ball Grid Array bezeichnet, unter dem Display und/oder Halbleiterbauteil vor, sodass das Halbleiterdisplay und/oder das Halbleiterbauteil direkt auf einem IC montierbar sind, zum Beispiel mittels Löten.

Gemäß zumindest einer Ausführungsform wird eine Optik gemeinsam über mehreren Halbleitersäulen angebracht. Damit kann die Strahlung mehrerer Halbleitersäulen etwa zu einem Bildpunkt oder Farbbereich für einen Bildpunkt vereinigt werden. Alternativ ist für einzelne Halbleitersäulen je eine separate Optik vorgesehen. Zum Beispiel sind kugelförmige Tropfen um die Halbleitersäulen erzeugt.

Gemäß zumindest einer Ausführungsform sind die Halbleitersäulen nicht stehend und/oder senkrecht zu einem Träger oder den Hauptseiten des Vergusskörpers angeordnet, sondern liegend. Damit können Längsachsen der Halbleitersäulen quer, insbesondere parallel, zu Hauptausdehnungsrichtungen des Halbleiterdisplays orientiert sein. Eine Abstrahlung der Halbleitersäulen erfolgt dann bevorzugt primär durch deren Seitenflächen und nicht oder nur sekundär über die Spitzen. Die Längsachsen der Halbleitersäulen und die bevorzugte Abstrahlrichtung bilden einen Winkel von einschließlich 0° bis kleiner 90°, insbesondere von höchstens 45° oder 30° oder 15° und/oder von mindestens 5° oder 15°.

Nachfolgend werden ein hier beschriebenes Halbleiterdisplay, ein hier beschriebenes optoelektronisches Halbleiterbauteil sowie ein hier beschriebenes Verfahren unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figuren 1: bis 5 und 7 schematische Illustrationen in Schnittdarstellungen, perspektivischen Darstellungen und Draufsichten von Verfahrensschritten von hier beschriebenen Verfahren zur Herstellung von Ausführungsbeispielen von hier beschriebenen Halbleiterdisplays und optoelektronischen Halbleiterbauteilen, die optoelektronischen Halbleiterbauteilen und die Verfahren sind nicht Teil der beanspruchten Erfindung. und
- Figur 6: schematische Schnittdarstellungen von Ausführungsbeispielen von hier beschriebenen Halbleiterdisplays.

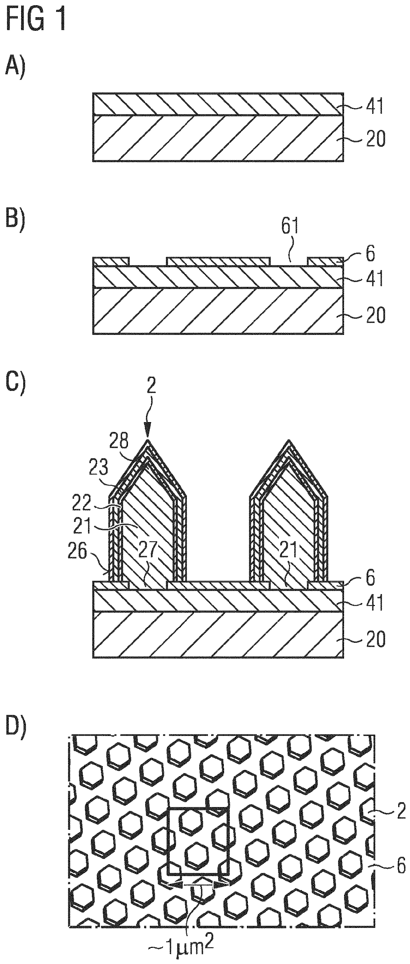

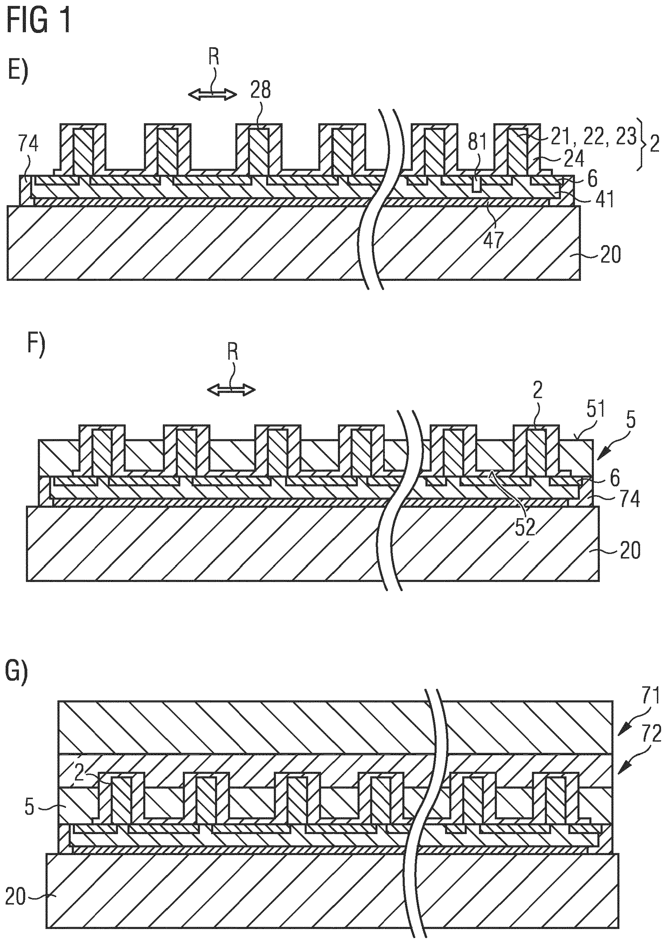

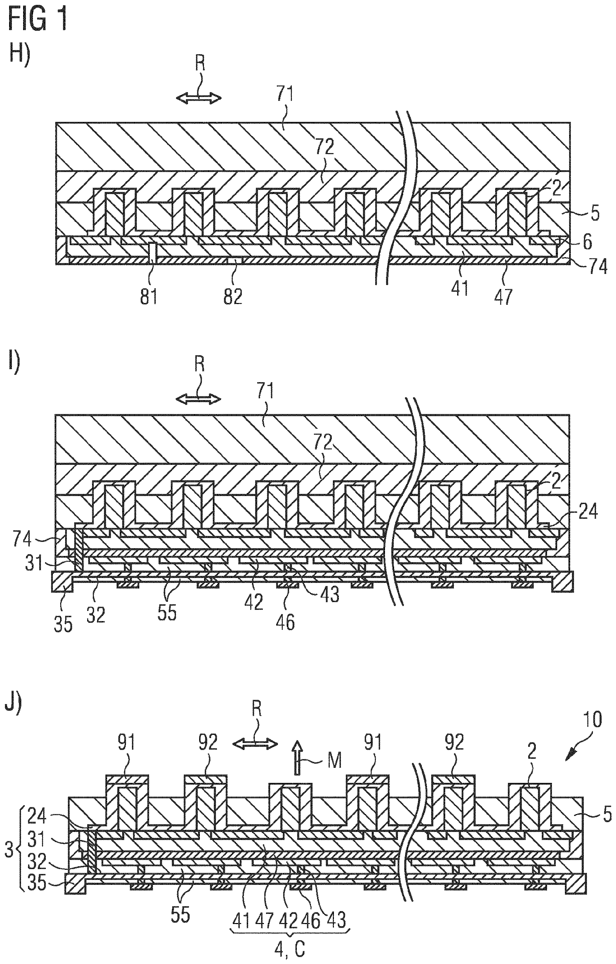

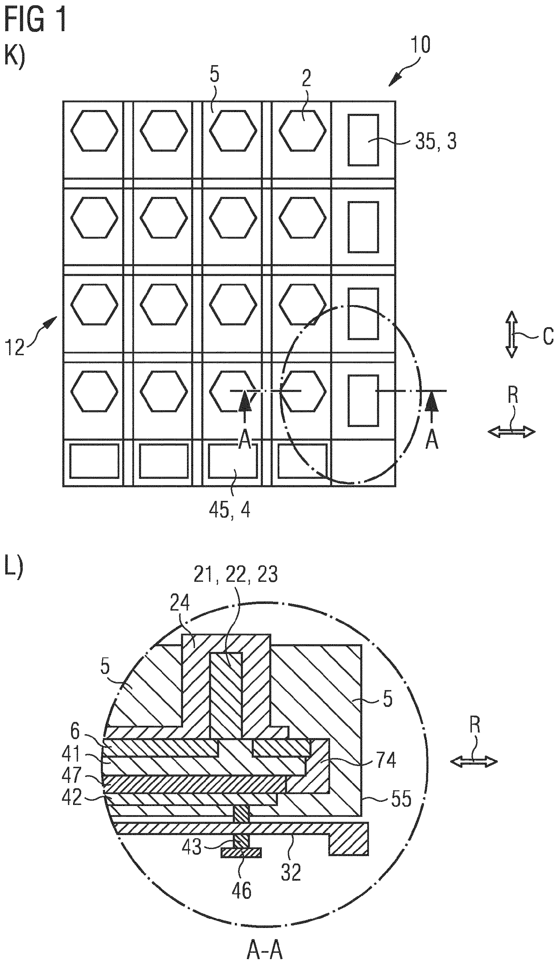

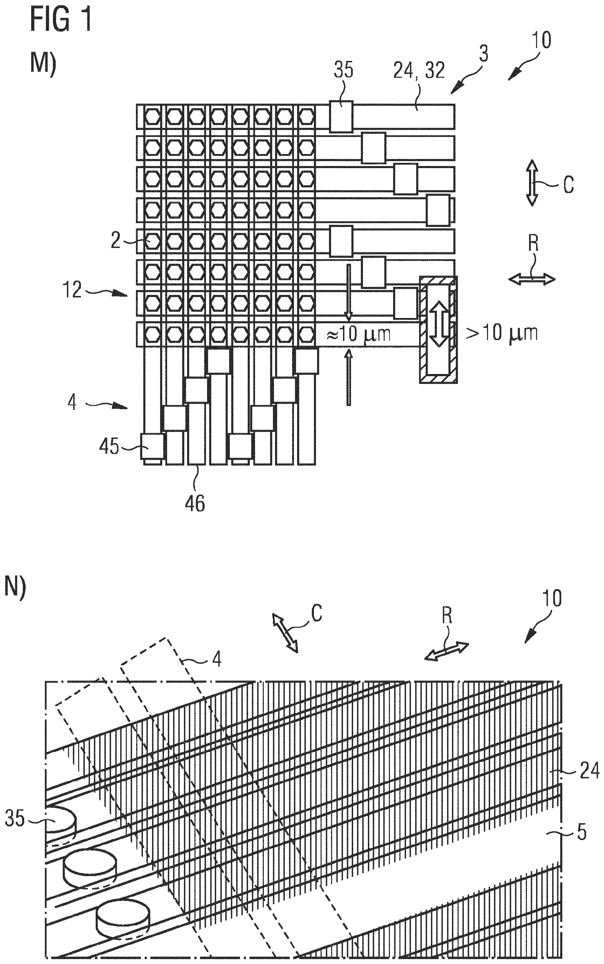

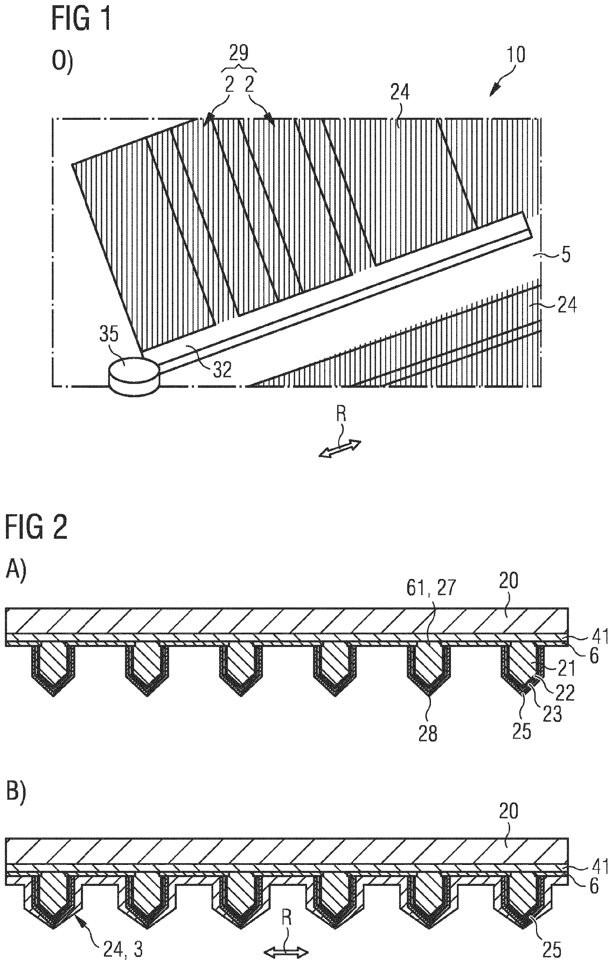

In Figur 1 ist ein Verfahren zur Herstellung von Halbleiterdisplays 1 beschrieben. Das Verfahren ist als solches nicht Teil der beanspruchten Erfindung. Gemäß der Schnittdarstellung in Figur 1A wird ein Aufwachssubstrat 20 bereitgestellt. Bei dem Aufwachssubstrat 20 handelt es sich beispielsweise um ein Saphirsubstrat oder um ein Siliziumsubstrat. Auf dem Aufwachssubstrat 20 wird eine bevorzugt n-leitende Halbleiterschicht 41 flächig aufgewachsen. Bei der Halbleiterschicht 41 handelt es sich etwa um eine n-leitende GaN-Schicht.
Im Verfahrensschritt der Figur 1B wird bevorzugt zuerst durchgehend eine Maskenschicht 6 abgeschieden. Anschließend werden mehrere Öffnungen 61 etwa fotolithografisch in der Maskenschicht 6 erzeugt. Alternativ ist es möglich, dass die Maskenschicht 6 mit den Öffnungen 61 selbstorganisierend aufgebracht wird. Beispielsweise handelt es sich bei der Maskenschicht 6 um eine SiN-Schicht oder eine SiO₂-Schicht.

In Figur 1C ist illustriert, dass ausgehend von den Öffnungen 61 jeweils Halbleiterkerne 21 gewachsen werden. Die Halbleiterkerne 21 werden bevorzugt mit einer Höhe gewachsen, die ähnlich einem mittleren Durchmesser der in Draufsicht gesehen hexagonalen Halbleiterkerne 21 ist, entsprechend einem Aspektverhältnis nahe 1, etwa zwischen einschließlich 0,8 und 2. Alternativ können die Halbleiterkerne 21 und damit die Halbleitersäulen 2 deutlich höher sein als breit, sodass das Aspektverhältnis beispielsweise zwischen einschließlich 5 und 10 liegt. Die Halbleiterkerne 21 sind etwa aus n-dotiertem GaN.

Auf die Halbleiterkerne 21 wird mindestens eine aktive Schicht 22 aufgewachsen. Die aktive Schicht 22, beispielsweise eine Einfachquantentopfstruktur oder eine Mehrfachquantentopfstruktur, umfasst bevorzugt mindestens eine Quantentopfschicht etwa aus InGaN und kann zudem Barriereschichten beinhalten.

Auf die aktive Schicht 22 wird jeweils eine Halbleiterhülle 23 gewachsen, insbesondere aus p-dotiertem GaN. Somit resultieren Halbleitersäulen 2, ausgehend von Basisbereichen 27 an der n-leitenden Halbleiterschicht 41 und hin zu Spitzen 28.

In Figur 1D ist eine Draufsicht gezeigt. Zu sehen sind die Halbleitersäulen 2 aus Figur 1C, die aus der Maskenschicht 6 herausragen. Die Halbleitersäulen 2 sind beispielsweise in einem hexagonalen Muster angeordnet, können abweichend von der Darstellung in Figur 1D auch in einem quadratischen oder rechteckigen Muster angeordnet sein. In Draufsicht gesehen weisen die Halbleitersäulen 2 je eine Fläche von weniger als 1 µm² auf.

In der Schnittdarstellung in Figur 1E ist illustriert, dass über die Halbleiterhüllen 23 hinweg entlang einer Zeilenrichtung R bevorzugt durchgehend eine elektrisch leitfähige Bestromungshülle 24 aufgebracht wird. Die Bestromungshülle 24 ist bevorzugt aus einem transparenten leitfähigen Oxid wie ITO oder alternativ aus einem reflektierenden Metall wie Silber oder aus beidem. Die Bestromungshüllen 24 sind bevorzugt unmittelbar an das Halbleitermaterial der Halbleitersäulen 2 angeformt und somit dreidimensional geformt.

Ferner ist der Figur 1E zu entnehmen, dass sich zwischen dem Aufwachssubstrat 20 und der n-leitenden Schicht 41 optional eine Pufferschicht 47 befindet, etwa aus dotiertem oder undotiertem GaN. Über die Pufferschicht 47 kann eine elektrische Leitfähigkeit in Kombination mit der n-leitenden Halbleiterschicht 41 erhöht werden. Alternativ ist die Pufferschicht 47 aus einem TCO oder einem Metall oder einem Halbleitermaterial wie Silizium.

An seitlichen Rändern eines Abstrahlfeldes 12 mit den Halbleitersäulen 2 des jeweiligen Displays 10 kann sich ein Randschutz 74 befinden. Der Randschutz 74 ist etwa aus einem Oxid oder Nitrid oder Kunststoff und bedeckt Seitenflächen der Schichten 41, 47 bevorzugt vollständig. In Richtung weg von dem Substrat 20 kann die Randschutz 74 bündig mit der Maskenschicht 6 abschließen.

In Figur 1E ist zudem schematisch gezeigt, dass die Spitzen 28 abgeflacht sein können. Entsprechendes kann auch in allen anderen Ausführungsbeispielen gelten. Bevorzugt jedoch sind die Spitzen 28 pyramidal geformt, wie in Figur 1C illustriert.

Optional können in der Maskenschicht 6 und/oder der n-dotierten Halbleiterschicht 41 und/oder in der optionalen Pufferschicht 47 Unterbrechungen 81 erstellt werden. Über diese Unterbrechungen 81 sind senkrecht zur Zeichenebene verlaufende Spalten C elektrisch voneinander trennbar.

In Figur 1F ist gezeigt, dass ein Vergusskörper 5 bevorzugt aus einem Kunststoff erzeugt wird. Der Vergusskörper 5 ist beispielsweise aus einem Epoxid, etwa mit Ruß als schwarzem Füllstoff, kann aber auch eine andere Farbe aufweisen. Der Vergusskörper 5 wird auf die Maskenschicht 6 sowie die Bestromungshüllen 24 unmittelbar aufgebracht. Damit liegt eine zweite Hauptseite 52 des Vergusskörpers 5 stellenweise unmittelbar an der Maskenschicht 6 sowie den Bestromungshüllen 24 an. Eine dem Aufwachssubstrat 20 abgewandte erste Hauptseite 51 des Vergusskörpers 5 ist bevorzugt eben gestaltet und wird von den Halbleitersäulen 2 überragt.

Gemäß Figur 1G wird ein temporäres Verbindungsmittel 72 aufgebracht, beispielsweise ein Klebstoff. Mittels des Verbindungsmittels 72, das die Halbleitersäulen 2 planarisiert, wird ein Hilfsträger 71 angebracht.

Daraufhin wird, siehe Figur 1H, das Aufwachssubstrat 20 entfernt, etwa mittels eines Laserabhebeverfahrens, auch als Laser Lift Off oder kurz LLO bezeichnet.

Zur elektrischen Separierung in die Spalten C senkrecht zur Zeichenebene können unterschiedlich tiefe Unterbrechungen 81, 82 zwischen benachbarten Spalten C gefertigt werden. Die beispielhafte Unterbrechung 81 reicht bis an oder bis in die Maskenschicht 6. Die exemplarische Unterbrechung 82 ist dagegen auf die Pufferschicht 47 begrenzt oder kann auch bis in die n-leitende Halbleiterschicht 41 reichen, bevorzugt jedoch nicht bis zur Maskenschicht 6.

In der Schnittdarstellung der Figur 1I ist gezeigt, dass mehrere elektrische Verbindungskomponenten erstellt werden.

So wird spaltenweise, also in Richtung senkrecht zur Zeichenebene, unter den Halbleitersäulen 2 jeweils ein Spiegel 42 angebracht, beispielsweise aus Silber. Die Spiegel 42 können sich direkt an der optionalen Pufferschicht 47 oder auch direkt an der n-leitenden Halbleiterschicht 41 befinden.

Zur elektrischen Isolation der Spiegel 42 von weiteren leitfähigen Komponenten wird ein Isolierkörper 55 erzeugt, beispielsweise über ein Spritzgießen oder Spritzpressen oder Drucken. Durch den Isolierkörper 55 werden elektrische Durchkontaktierungen 31, 43 geführt. Die Durchkontaktierungen 31 der ersten Kontaktleisten 3 verbinden die zeilenweisen Bestromungshüllen 24 mit optionalen Kontaktstegen 32, bevorzugt aus einem Metall, entlang der Zeilen R. Alternativ können die Durchkontaktierungen 31 direkt zu den Kontaktflächen 35 der ersten Kontaktleiste 3 reichen.

Ausgehend von den Spiegeln 42 reichen die Durchkontaktierungen 43 der zweiten Kontaktleisten 4 hin zu Stromschienen 46, bevorzug aus einem Metall. Die Kontaktstege 32 sind bevorzugt von dem Isolierkörper 55 abgedeckt, wie auch abweichend von der Darstellung in Figur 1I optional für die Stromschienen 46 möglich.

Gemäß Figur 1J werden der Hilfsträger 71 und das Verbindungsmittel 72 entfernt. Daraufhin können optional erste und zweite Leuchtstoffschichten 91, 92 auf einige der Halbleitersäulen 2 aufgebracht werden. Mit den ersten Leuchtstoffschichten 91 wird beispielsweise rotes Licht erzeugt und mit den zweiten Leuchtstoffschichten 92 beispielsweise grünes Licht. Die nicht von den Leuchtstoffschichten 91, 92 bedeckten Halbleitersäulen 2 emittieren bevorzugt blaues Licht. Mit den Leuchtstoffschichten 91, 92 sind somit RGB-Bildpunkte realisierbar. Solche Leuchtstoffschichten 91, 92 können auch in allen anderen Ausführungsbeispielen vorhanden sein und sind bevorzug zur Vollkonversion von blauem Licht eingerichtet. Emittieren die Halbleitersäulen 2 ultraviolette Primärstrahlung, so kann ein weiterer, nicht gezeichneter Leuchtstoff zur Erzeugung von blauem Licht vorhanden sein. Die Leuchtstoffe 91, 92 müssen nicht unbedingt auf die Halbleitersäulen 2 beschränkt sein, sondern können sich auch auf den Vergusskörper 5 erstrecken.

Die Umverdrahtung, wie in Figur 1J dargestellt, wird beispielsweise über eine Mold Support Technologie, kurz MST, erstellt. Ein Bereich von der Maskenschicht 6 bis zu den Kontaktflächen 35, 45 weist beispielsweise eine Dicke von einigen 10 µm auf, beispielsweise von mindestens 20 µm oder 40 µm und/oder von höchstens 200 µm oder 50 µm, und trägt zur mechanischen Stabilisierung des Halbleiterdisplays 10 maßgeblich bei. Dahingegen weist der Vergusskörper 5 mit den Halbleitersäulen 2 aufwärts der Maskenschicht 6 beispielsweise lediglich eine erheblich geringere Dicke von wenigen Mikrometer auf, beispielsweise von höchsten 5 µm oder 3 µm. Anstelle des Isolierkörpers 55 kann eine mechanische Stabilisierung des Halbleiterdisplays 10 auch durch eine Verdickung der Kontaktflächen 35, insbesondere galvanisch, erzielt werden.

Ebenso abweichend von der Darstellung in Figur 1J ist es möglich, dass der Vergusskörper 5 in Richtung weg von der Maskenschicht 6 bündig mit den Halbleitersäulen 2 oder bündig mit den Leuchtstoffschichten 91, 92 abschließt oder auch die Halbleitersäulen 2 oder Leuchtstoffschichten 91, 92 überragt. Dabei bleiben die der Maskenschicht 6 abgewandten Oberseiten der Halbleitersäulen 2 bevorzugt frei von dem Vergusskörper 5.

Alternativ oder zusätzlich zu den Leuchtstoffschichten 91, 92 können auch Optiken wie Linsen zusammenhängend oder einzeln über den Halbleitersäulen 2 erzeugt werden.

In Figur 1K ist eine Draufsicht gezeigt, Figur 1L beschreibt eine Schnittdarstellung einer Detailansicht der Figur 1K entlang der Linie A-A. Zu erkennen ist, dass über die Kontaktstege 32 und Stromschienen 46 die Halbleitersäulen 2 bildpunktweise und/oder einzeln mit den elektrischen Kontaktflächen 35, 45 verbunden sind, sodass die Halbleitersäulen 2 matrixartig elektrisch separat und entlang der Spalten C und Zeilen R ansteuerbar sind.

Dadurch, dass die Maskenschicht 6 in dem fertigen Bauteil 10 noch vorhanden ist, ist inhärent eine Verkapselung der einzelnen Segmente für die Bildpunkte gegeben. Eventuell offenliegende Kontakte können beispielsweise mittels Siliziumdioxid, aufgebracht insbesondere über Atomlagenabscheidung, kurz ALD, oder CVD, geschützt werden. Die insbesondere SMT-fähigen Kontaktflächen 35, 45 der Fan Out-Struktur können galvanisch verstärkt werden.

In Figur 1M ist in einer Draufsicht schematisch dargestellt, dass sich die Kontaktflächen 45, 35 außerhalb des Abstrahlfeldes 12 mit den Halbleitersäulen 2 in einem sogenannten Fan Out-Bereich befinden. Die einzelnen Kontaktflächen 35, 45 sind entlang der Spaltenrichtung C und der Zeilenrichtung R bevorzugt versetzt zueinander angeordnet. Hierdurch ist es möglich, dass die Kontaktflächen 35 gegenüber den Kontaktstegen 32 und den Stromschienen 46 verbreitert sind. So weisen die Kontaktstege 32 sowie die Stromschienen 46 bevorzugt Breiten von ungefähr 1 µm auf. Demgegenüber liegen, exemplarisch für eine der Kontaktflächen 35 der ersten Kontaktleisten 3 illustriert, Breiten und/oder Längen der Kontaktflächen 35 bevorzugt bei mindestens 10 µm. Diese Vergrößerung der Kontaktflächen 35, 45 ist insbesondere durch die versetzte Anordnung ermöglicht.

In der Ausführungsform der Figur 1N befinden sich die Kontaktflächen 35 der ersten Kontaktleisten 3 an derselben Seite der Maskenschicht 6 wie die Halbleitersäulen 2. Die zweiten Kontaktleisten 4 verlaufen an einer Unterseite, analog zu Figur 1J. die Kontaktflächen 35 an der Oberseite, wie in Figur 1N gezeigt, sind beispielsweise über Bonddrähte kontaktierbar.

Beim Ausführungsbeispiel der Figur 1O sind mehrere der Halbleitersäulen 2 zu Gruppen 29 zusammengefasst. Die Gruppen 29 sind beispielsweise durch die Kontaktstege 32 elektrisch miteinander verbunden und an eine gemeinsame Kontaktfläche 35 angekoppelt. Eine solche Gruppierung von bevorzugt nur wenigen Halbleitersäulen 2 zu den Gruppen 29 kann entsprechend auch in allen anderen Ausführungsbeispielen erfolgen, unabhängig von dem genauen Kontaktschema hin zu den Kontaktflächen 35, 45. Die Gruppierung kann an den ersten und/oder an den zweiten Kontaktleitungen 3, 4 durchgeführt werden.

Bei der Verschaltung über die Kontaktleitungen 3, 4 handelt es sich insbesondere um eine Kreuzmatrixschaltung, wie bevorzugt auch in allen anderen Ausführungsbeispielen.

Wie auch in allen anderen Ausführungsbeispielen können die Kontaktstege 32 lichtdurchlässig und aus einem transparenten leitfähigen Oxid wie ITO sein. Alternativ handelt es sich bei den Kontaktstegen 32 um metallische Leiterbahnen, die bevorzugt teilweise oder vollständig neben den Halbleitersäulen 2 angebracht sind, in Draufsicht gesehen. Entsprechendes gilt hinsichtlich der Stromschienen 46.

Durch das Zusammenschalten mehrerer Halbleitersäulen 2 zu einer Gruppe 29 werden erhöhte Toleranzen beim beschriebenen Anschlusskonzept erzielt, zudem können Halbleitersäulen 2 redundant beschaltet sein. Die einzelnen Halbleitersäulen 2 sind in dem fertigen Halbleiterdisplay 10 bevorzugt voneinander beabstandet angeordnet, sodass zwischen den Anschlüssen für die Zeilen R und Spalten C ein Abstand von beispielsweise mindestens 2 µm oder 5 µm für metallische Leiterbahnen 32, 46 verfügbar bleibt.

Die hier beschriebenen Halbleiterdisplays 10 sind kosteneffizient herstellbar, etwa da eine Chipmontagetechnik entfällt. Zudem ist eine hohe Lebensdauer erreichbar, auch, da Komponenten, insbesondere die Halbleitersäulen 2, elektrisch redundant verschaltet sein können. Es ist ein großer Temperaturbereich für Anwendungen, beispielsweise von -20 °C bis 100 °C, zugänglich, sodass das Halbleiterdisplay 10 in hitzeanfälligen Elektronikteilen etwa bei direkter Sonneneinstrahlung verwendet werden kann. Es sind hohe Bildaufbauraten sowie ein hohes Kontrastverhältnis erzielbar. Die Ansteuertechnik ist bevorzugt kompatibel mit herkömmlichen Ansteuertechniken. Ferner ist das Halbleiterdisplay 10 von der Größe her skalierbar herstellbar. Über die Fan Out-Kontaktierung, also die Gestaltung der Kontaktflächen 35, 45 außerhalb des Abstrahlfeldes 12, ist eine effiziente Anbringung an Steuerchips möglich.

Die hier beschriebenen Halbleiterdisplays 10 können beispielsweise im sogenannten Industrial Imaging etwa in Datendisplays, Medizinanwendungen oder Simulationsanwendungen verwendet werden. Ferner ist eine Anwendung in sogenannten HUDs und HMDs etwa im Automobilbereich, Luftfahrtbereich oder Verteidigungsbereich möglich. Die Halbleiterdisplays 10 können als Projektionseinrichtungen etwa für Interferenzmuster, Metrologie, dreidimensionalen Sensoren, 3D-Drucker oder Prototypenherstellung, Lithografie oder Infrarotprojektion verwendet werden.

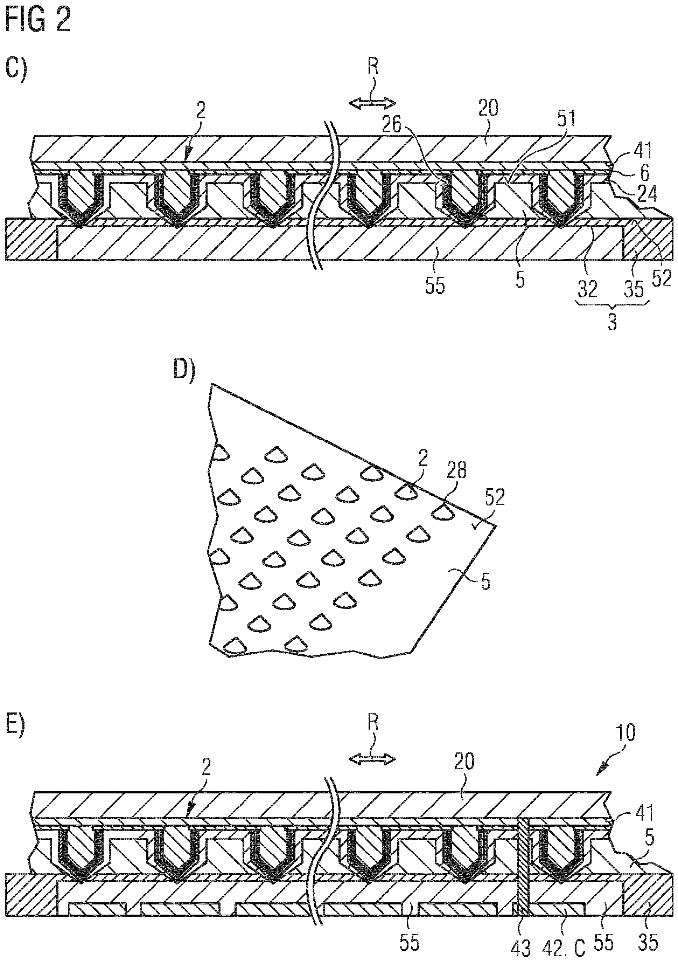

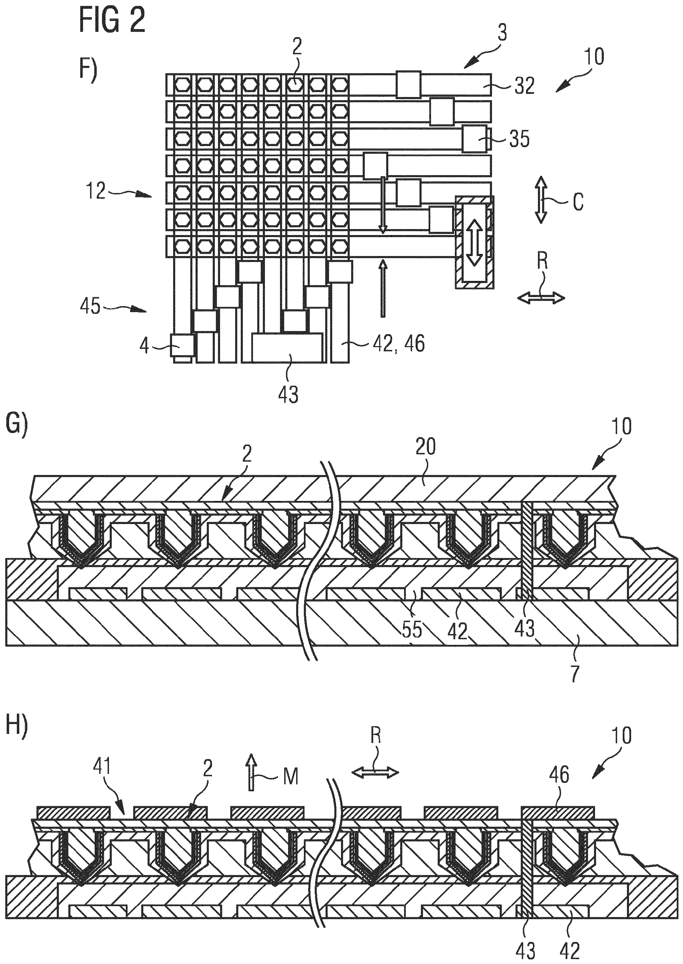

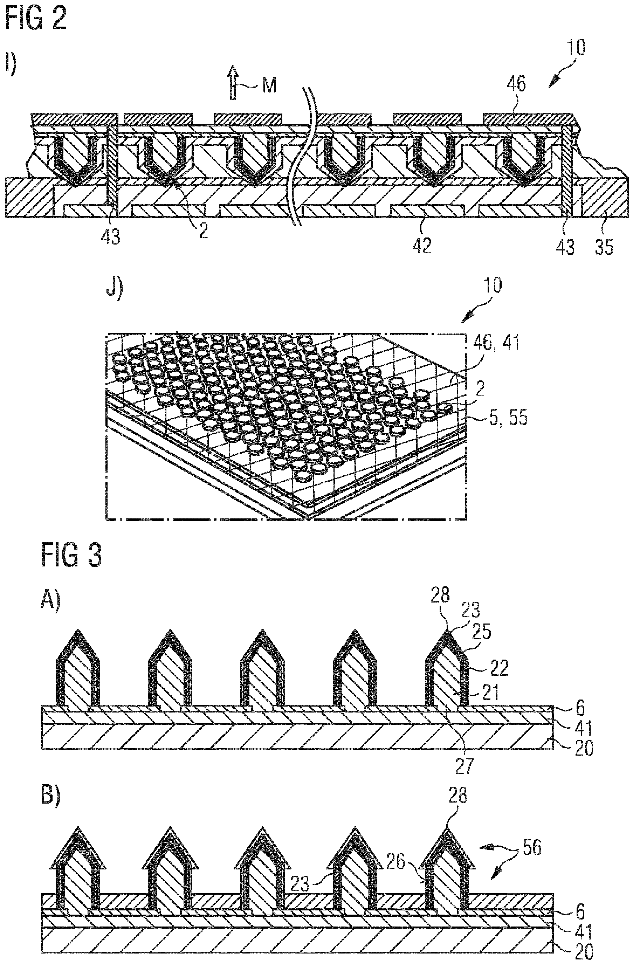

Auch mit den Verfahren der Figur 2 lässt sich ein fein pixeliertes LED-Display 10 oder ein LED-Projektorchip basierend auf den Halbleitersäulen 2 realisieren. Das Verfahren ist als solches nicht Teil der beanspruchten Erfindung. Analog zu den Figuren 1A bis 1C wird gemäß der Schnittdarstellung in Figur 2A eine Vielzahl von Halbleitersäulen 2, ausgehend von der n-dotierten Halbleiterschicht 41 und der darauf angebrachten Maskenschicht 6, erzeugt. Zusätzlich zu den Halbleiterkernen 21, den aktiven Schichten 22 und den Halbleiterhüllen 23 sind optional Zusatzschichten 25 vorhanden, die zum Beispiel auf die Halbleiterhüllen 23 aufgebracht sind.

In Figur 2B ist gezeigt, dass direkt auf die Zusatzschichten 25 die Bestromungshüllen 24 aufgebracht werden. Die Bestromungshüllen 24 werden entlang der Zeilen R bevorzugt durchgängig aufgebracht.

In der Schnittdarstellung der Figur 2C ist gezeigt, dass auf die Bestromungshüllen 24 um die Halbleitersäulen 2 herum der Vergusskörper 5 aufgebracht wird, der beispielsweise aus einem schwarzen Epoxid ist. In Richtung weg von dem Aufwachssubstrat 20 folgen dem Vergusskörper 5 an der zweiten Hauptseite 52 die Kontaktstege 32 nach, die bevorzugt zeilenförmig strukturiert sind. Die Kontaktstege 32 werden von dem Isolierkörper 55 bedeckt, aus dem die Kontaktflächen 35 herausragen.

Die zweite Hauptseite 52 vor dem Erzeugen der Kontaktstege 32 ist in Figur 2D in einer perspektivischen Draufsicht gezeigt. Die Spitzen 28 der Halbleitersäulen 2 ragen aus dem Vergusskörper 5 heraus. Damit sind die Bestromungshüllen 24 an den Spitzen 28 über die Kontaktstege 32 kontaktierbar. Dabei sind die Kontaktstege 32 bevorzugt auf den Bereich der Spitzen 28 beschränkt, sodass die Seitenflächen 26 der Halbleitersäulen 2 frei von den Kontaktstegen 32 sein können.

Abweichend von der Darstellung in Figur 2D ist es möglich, dass die Halbleitersäulen 2 unterschiedlich weit aus dem Vergusskörper 5 herausragen, sodass etwa eine periodische Niveauänderung insbesondere mittels des Vergusskörpers 5 und/oder über unterschiedliche Höhen der Halbleitersäulen 2 und/oder über eine variierende Dicke einer nicht gezeichneten Füllschicht erreichbar ist. So können die Halbleitersäulen 2 mit unterschiedlichen Abstrahlhöhen freigelegt sein. Damit ist eine winkelabhängige Abstrahlung erreichbar. Gleiches gilt für alle anderen Ausführungsbeispiele.

Gemäß der Schnittdarstellung in Figur 2E werden durch den Vergusskörper 5 und den Isolierkörper 55 hindurch die Durchkontaktierungen 43 für die zweiten Kontaktleisten 4 erzeugt. Über diese Durchkontaktierungen 43 ist die zum Beispiel durchgehende n-leitende Halbleiterschicht 41 mit den Spiegeln 42 für die Spaltenkontakte C verbunden.

Die Durchkontaktierungen 31, 43 liegen dabei, siehe die Draufsicht in Figur 2F, bevorzugt außerhalb des Abstrahlfeldes 12. Ebenso wie die Kontaktflächen 35 können die Durchkontaktierungen 31, 43 außerhalb des Abstrahlfeldes 12 in Draufsicht gesehen eine größere Grundfläche aufweisen, insbesondere eine größere Breite, als die zugehörigen Stromschienen 46 und Kontaktstege 32. Die Stromschienen 46 können in diesem Fall identisch sein zu den als Spaltenkontakten gestalteten, bevorzugt metallischen Spiegeln 42.

In der Schnittdarstellung der Figur 2G ist illustriert, dass optional ein Träger 7 angebracht wird. Über den Träger 7 ist das Halbleiterdisplay 10 mechanisch stabilisiert und mechanisch eigenständig handhabbar. Ein solcher Träger 7 kann auch in allen anderen Ausführungsbeispielen vorhanden sein. Der Träger 7 kann elektrische Schaltungen und Steuerelemente zur Ansteuerung des Halbleiterdisplays 10 beinhalten.

In Figur 2H ist gezeigt, dass auf die n-leitende Halbleiterschicht 41 die lichtdurchlässigen Stromschienen 46 aufgebracht werden. Die Stromschienen 46 können die Halbleitersäulen 2 vollständig überdecken. Bevorzugt sind die Stromschienen 46 aus einem für die erzeugte Strahlung durchlässigen Material wie ITO. Damit erfolgt eine Hauptemission M durch die Stromschienen 46 hindurch.

In Figur 2I ist illustriert, dass die Durchkontaktierungen 43 für die zweite Kontaktleisten 4 anders platziert sein können.

In Figur 2I ist, wie auch in den Figuren 2G und 2H, nur eine oder sind nur zwei der Durchkontaktierungen 43 gezeigt. Bevorzugt ist für jede der Spalten C mindestens eine solche Durchkontaktierung 43 vorhanden, bevorzugt genau zwei Durchkontaktierungen, an jedem Anfang und an jedem Ende der Zeilen R und der Spalten C.

Ebenso ist in den Figuren 2G, 2H und 2I die n-dotierte Halbleiterschicht 41 jeweils durchgehend gezeichnet. Alternativ hierzu ist es analog zu Figur 1H möglich, dass in Figur 2 nicht gezeichnete Unterbrechungen 81, 82 vorhanden sind, sodass die n-leitende Halbleiterschicht 41 dann spaltenweise strukturiert ist. Gleiches gilt für alle anderen Ausführungsbeispiele.

Solche Unterbrechungen 81, 82, analog zu Figur 1H, können beispielsweise mittels Plasmaätzen hergestellt werden. In Draufsicht gesehen können diese Unterbrechungen 81, 82, wie auch in allen anderen Ausführungsbeispielen, wie die Halbleitersäulen 2 hexagonal oder abweichend hiervon alternativ kreisförmig, quadratisch oder rechteckig gestaltet sein.

In Figur 2J ist eine perspektivische Darstellung des Halbleiterdisplays 10 gezeigt. Von oben sind die einzelnen Halbleitersäulen 2 erkennbar, die in dem Vergusskörper 5 sowie in dem Isolierkörper 55 eingebettet sind. Abgedeckt sind die Halbleitersäulen 2 von der lichtdurchlässigen n-leitenden Halbleiterschicht 41 sowie von den lichtdurchlässigen Stromschienen 46.

Anders als im Zusammenhang mit Figur 1 ist es beim Verfahren der Figur 2 nicht erforderlich, dass die strahlungsdurchlässigen Stromschienen 46 die Halbleitersäulen 2 nachformen, anders als die strahlungsdurchlässigen Bestromungshüllen 24 der Figur 1. Die Stromschienen 46 der Figur 2 sind bevorzugt eben und planar geformt. Dies bedeutet insbesondere, dass die einzelnen Halbleitersäulen 2 und damit Bildpunkte des Halbleiterdisplays 10 in Abstrahlrichtung eine planare Oberfläche aufweisen können. Das Licht wird in der pyramidenförmigen und/oder prismenförmigen aktiven Schicht 22 erzeugt und gemäß Figur 2 mittels der als Spiegel fungierenden, reflektierenden Bestromungshülle 24, etwa aus Silber, entlang der Hauptemissionsrichtung M gelenkt.

Damit bilden in Figur 2 zeilenförmige TCO-Kontakte auf der Abstrahlseite die elektrischen Anschlüsse für die n-Seiten 27 der Halbleitersäulen 2. Diese TCO-Kontakte 46 können, abweichend von der Darstellung in Figur 2, zusätzlich mit Metallbahnen kombiniert sein. Solche Metallbahnen können die Halbleitersäulen 2 in Draufsicht gesehen teilweise bedecken.

Wird für die Bestromungshüllen 24 kein reflektierendes und/oder ein teilweise für die erzeugte Strahlung durchlässiges Material verwendet, so ist es in allen Ausführungsbeispielen möglich, dass der Vergusskörper 5 als Reflektor gestaltet ist und beispielsweise durch Matrixmaterial wie ein Silikon mit einem reflektierenden Füllstoff wie Titandioxidpartikeln gebildet ist. Ferner ist es möglich, wie auch in allen anderen Ausführungsbeispielen, dass die Bestromungshüllen 24 aus mehreren Teilschichten zusammengesetzt sind, beispielsweise aus einer Schicht aus einem transparenten leitfähigen Oxid und einer oder mehreren Metallschichten.

Durch eine zusätzliche Metallbeschichtung für die Stromschienen 46, die über den Halbleitersäulen 2 verläuft, ist auch ein optisches Übersprechen zwischen benachbarten Bildpunkten und Halbleitersäulen 2 verhinderbar. Damit kann eine Lichtaustrittsöffnung pro Halbleitersäule 2 gegenüber einer Grundfläche der Halbleitersäule 2 verringert sein. Entsprechendes gilt für alle anderen Ausführungsbeispiele.

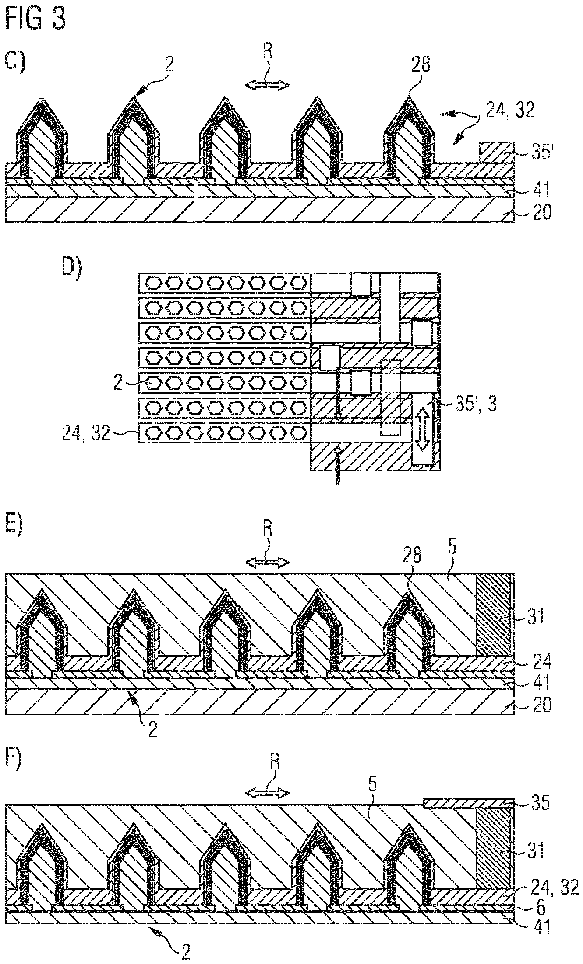

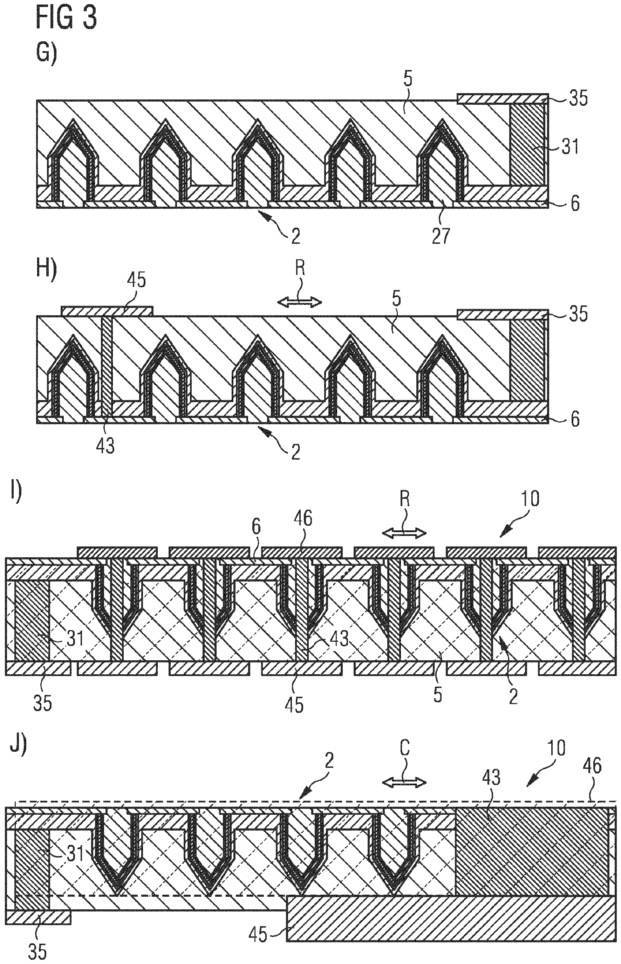

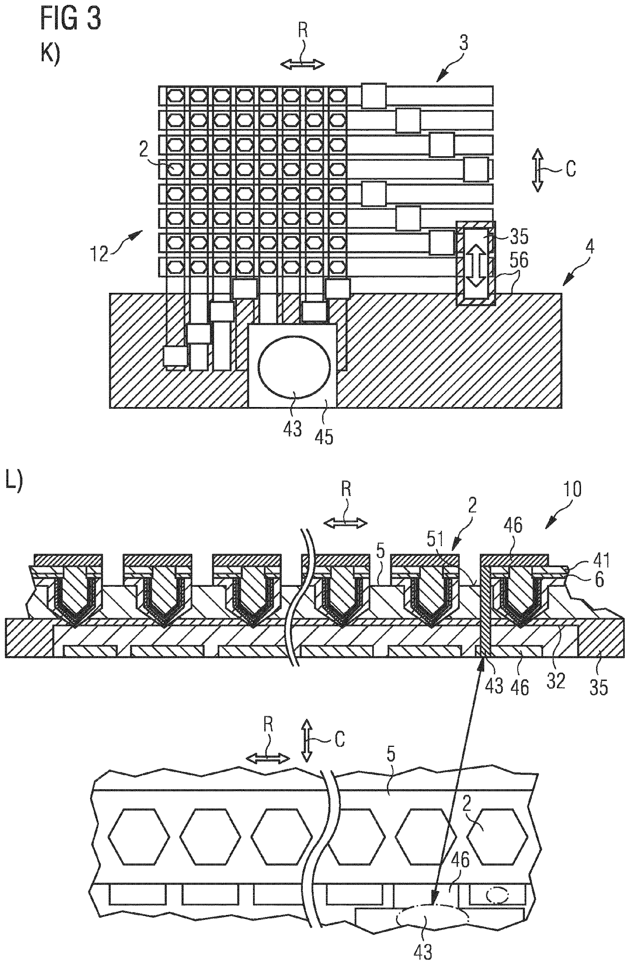

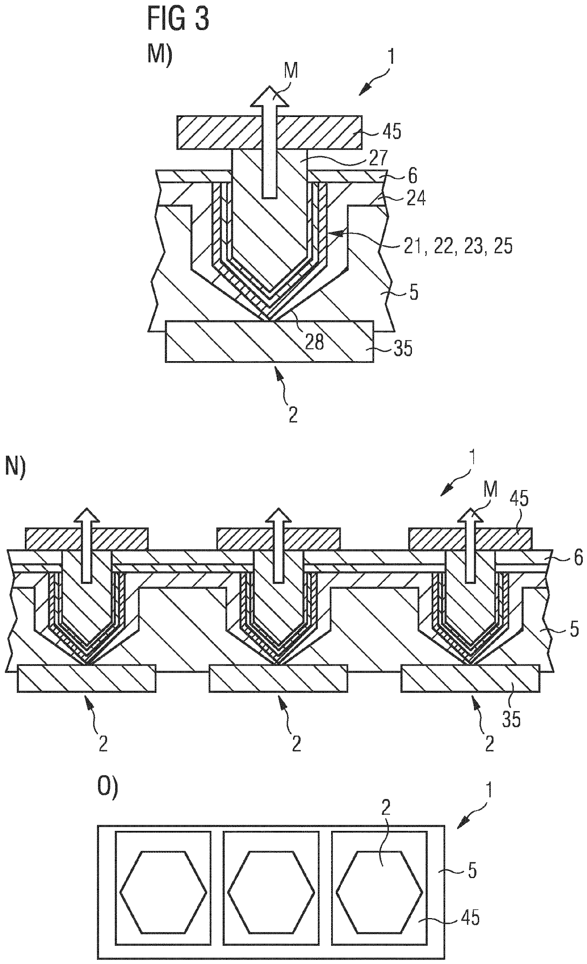

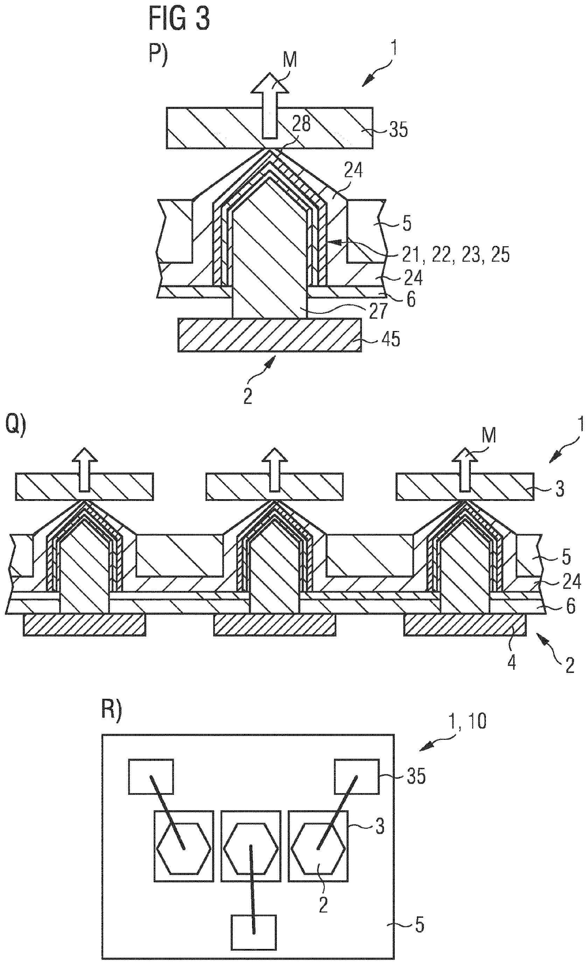

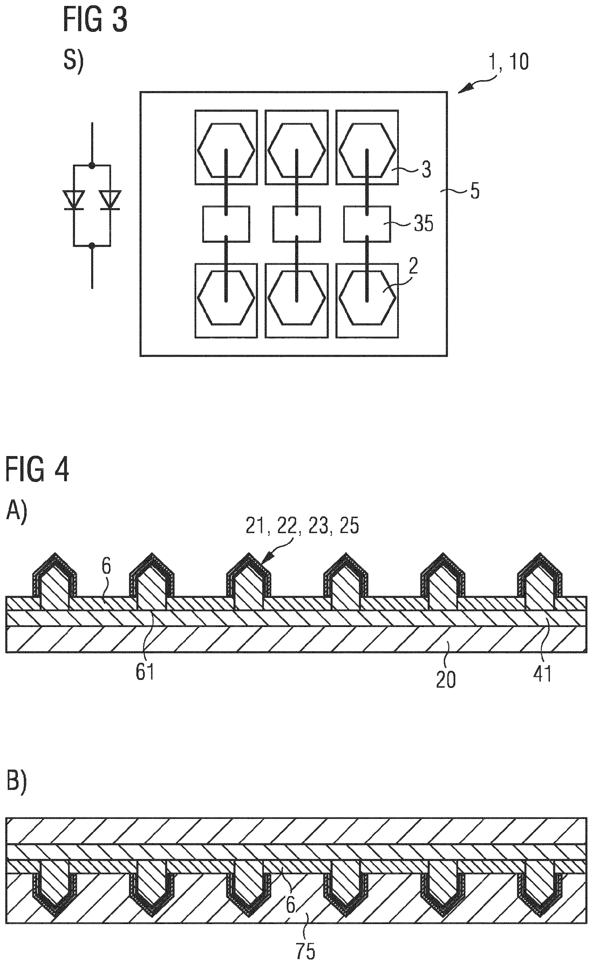

Beim Verfahren der Figur 3, siehe die Schnittdarstellung in Figur 3A, erfolgt das Wachstum der Halbleitermaterialien der Halbleitersäulen 2 analog zu den Figuren 1 oder 2. Gegenüber Figur 2 können die Zusatzschichten 25 auch unmittelbar auf den aktiven Schichten 22 aufgebracht sein, sodass die Halbleiterhüllen 23 das am weitesten außen liegende Halbleitermaterial der Halbleitersäulen 2 bilden.

Im optionalen Verfahrensschritt der Figur 3B wird eine Passivierungsschicht 56 bevorzugt über ein gerichtetes Aufbringverfahren erzeugt. Die Passivierungsschicht 56 ist beispielsweise aus einem Oxid wie Siliziumoxid oder einem Nitrid wie Siliziumnitrid, kann aber auch aus einem organischen Material wie ein Fotolack sein. Über eine solche Passivierungsschicht 56 ist es möglich, dass nachfolgend nur bereichsweise auf das Halbleitermaterial der Halbleitersäulen 2 elektrisch leitfähig die Bestromungshüllen 24 aufgebracht werden.

Bei dem Aufbringen der Passivierungsschicht 56, wie in Figur 3B gezeigt, sind nur die Seitenflächen 26 elektrisch kontaktierbar. Ein Bereich direkt an der Maskenschicht 26 und an den Spitzen 28 ist somit elektrisch nicht kontaktierbar und elektrisch geschützt. In diesem Falle kann insbesondere die Zusatzschicht 25 zu einer Stromaufweitung entlang der Halbleitersäulen 2 dienen. Die Passivierungsschicht 56 kann in den fertigen Displays 10 und Halbleiterbauteilen 1 noch teilweise oder vollständig vorhanden sein oder auch entfernt werden.

Gemäß der Schnittdarstellung in Figur 3C werden die Bestromungshüllen 24 aufgebracht, bevorzugt entlang der Zeilen R durchgängig. Die Bestromungshüllen 24 sind etwa aus einer Metallschicht wie Silber oder aus einer Kombination aus einer Silberschicht und einer transparenten leitfähigen Oxidschicht gebildet. Die Bestromungshüllen 24 werden beispielsweise durch Aufdampfen oder Sputtern erzeugt. An einem Rand ist ein Bereich 35' für die spätere Kontaktflächen 35 vorgesehen. Dies ist auch in der Draufsicht der Figur 3D schematisch illustriert.

Im Schritt, wie in der Schnittdarstellung der Figur 3E erläutert, wird der Vergusskörper 5 erzeugt, der sich über die Spitzen 28 der Halbleitersäulen 2 hinweg erstreckt und somit die Halbleitersäulen 2 vollständig bedeckt. Ausgehend von den Bestromungshüllen 24 und dem Bereich 35' werden die Durchkontaktierungen 31 für die einzelnen Zeilen C durch den Vergusskörper 5 hindurch erzeugt, beispielsweise galvanisch.

Nachfolgend werden, siehe Figur 3F, die Kontaktflächen 35 hergestellt, die die Durchkontaktierungen 31 vollständig bedecken können und sich teilweise darüber hinausgehend auf den Vergusskörper 5 erstrecken können.

Im optionalen Verfahrensschritt der Figur 3G wird die n-leitende Halbleiterschicht 41 teilweise oder vollständig entfernt, sodass die Basisbereiche 27 sowie die Maskenschicht 6 freigelegt werden. Somit bleibt die Maskenschicht 6 erhalten. Damit kann die Maskenschicht 6 als Passivierung für die Halbleitersäulen 2 dienen.

Im Schritt der Figur 3H ist gezeigt, dass die Durchkontaktierungen 43 für die Spaltenkontakte C durch den Vergusskörper 5 und die Maskenschicht 6 hindurch erstellt werden. An dem Vergusskörper 5 können zudem die elektrischen Kontaktflächen 45 erzeugt werden. Damit befinden sich die Kontaktflächen 35, 45 allesamt auf derselben Seite des Vergusskörpers 5, sodass das Halbleiterdisplay 10 später oberflächenmontierbar sein kann.

Im Schritt der Figur 3I werden die Durchkontaktierungen 43 mit den Stromschienen 46 versehen. Die Stromschienen 46 sind bevorzugt strahlungsdurchlässig und aus einem transparenten leitfähigen Oxid wie ITO. In Figur 3I ist darüber hinaus illustriert, dass die Durchkontaktierungen 43 entlang der Spalten C, also senkrecht zur Zeichenebene der Figur 3I, deckungsgleich zu den Halbleitersäulen 2 verlaufen können, anders als die versetzt angeordneten Durchkontaktierungen 43 der Figur 3H.

Dabei liegen die Durchkontaktierungen 43, wie in Figur 3J gezeichnet, bevorzugt außerhalb des Abstrahlfelds 12 mit den Halbleitersäulen 2. Dadurch können die Kontaktflächen 45 und/oder die Durchkontaktierungen 46 größer gestaltet werden, um eine einfachere elektrische Kontaktierung des Halbleiterdisplays 10 zu erreichen. Dies ist zudem in der Draufsicht der Figur 3K veranschaulicht.

Ein Durchmesser der Durchkontaktierung 43 liegt in Draufsicht gesehen beispielsweise bei mindestens 10 µm und/oder höchstens 200 µm, insbesondere bei ungefähr 50 µm.

Entsprechend große Durchkontaktierungen 31, 43 und/oder Kontaktflächen 35, 45 können in dem Fan Out-Bereich außerhalb des Abstrahlfeldes 12 auch in allen anderen Ausführungsbeispielen vorliegen.

In der Schnittdarstellung der Figur 3L und der zugehörigen Draufsicht, ebenfalls in Figur 3L, ist ein Halbleiterdisplay 10 ähnlich zu dem der Figur 2H dargestellt. Abweichend von Figur 2H ist jedoch die n-leitende Halbleiterschicht 41 zu den Spalten C strukturiert, sodass die n-leitende Halbleiterschicht 41 in Richtung senkrecht zur Zeichenebene in mehreren Streifen verläuft. Die Durchkontaktierungen 43 für die jeweiligen Spalten C befinden sich wiederum bevorzugt außerhalb des Abstrahlfeldes 12 mit den Halbleitersäulen 2.

Ebenso wie die n-leitende Halbleiterschicht 41 kann die Maskenschicht 6 strukturiert sein. Damit ist die erste Hauptseite 51 des Vergusskörpers 5 stellenweise freigelegt. Optional können diese freigelegten Bereiche des Vergusskörpers 5 und damit eventuell ebenso freigelegte Bereiche der Halbleitersäulen 2 optional mit einer nicht gezeichneten Schutzschicht versehen werden.

In Figur 3M ist ein Ausführungsbeispiel eines optoelektronischen Halbleiterbauteils 1 gezeigt. Die optoelektronischen Halbleiterbauteile nach Figuren 3M - 3S sind nicht Teil der beanspruchten Erfindung.

Das Halbleiterbauteil 1 gemäß Figur 3M weist genau eine Halbleitersäule 2 auf, die unmittelbar in den Vergusskörper 5 eingebettet ist. An der Spitze 28 befindet sich die p-Kontaktfläche 35, an dem Basisbereich 27 ist die n-Kotaktfläche 45 angebracht. Dabei ist die n-Kontaktfläche 45 transparent gestaltet und die p-Kontaktfläche 35 bevorzugt reflektierend, ebenso wie die Bestromungshülle 24. Damit erfolgt eine Emission M nur über den Basisbereich 27 und durch die n-Kontaktfläche 45 hindurch.

Das Halbleiterbauteil 1 der Figur 3M wird beispielsweise durch einen Vereinzelungsprozess wie ein Sägen oder Lasertrennen oder Brechen erzeugt, ausgehend von den Anordnungen, wie insbesondere in den Figuren 3E, 3G oder 3L dargestellt. Dabei können die Kontaktleisten 3, 4 und die zugehörigen Komponenten, mit Ausnahme der Kontaktflächen 35, 45, weggelassen werden.

Das Halbleiterbauteil 1 der Figur 3M weist beispielsweise laterale Abmessungen, in Richtung senkrecht zur Hauptemissionsrichtung M, von mindestens 0,5 µm und/oder von höchstens 3 µm auf. Entlang der Hauptabstrahlrichtung M liegt eine Ausdehnung des Halbleiterbauteils 1 beispielsweise bei mindestens 2 µm und/oder bei höchstens 15 µm. Bevorzugt ist das Halbleiterbauteil 1 mechanisch einzeln handhabbar und beispielsweise mit einer Pinzette oder Saugvorrichtung oberflächenmontierbar.

Beim Halbleiterbauteil 1 der Figur 3N sind drei der Halbleitersäulen 2 zusammengefasst und mechanisch über den Vergusskörper 5 verbunden. Die drei Halbleitersäulen 2 können elektrisch einzeln ansteuerbar sein oder, abweichend von der Darstellung in Figur 3M, auch elektrisch parallel geschaltet sein. Im Übrigen gelten die Ausführungen zur Figur 3M.

Eine Draufsicht auf das Halbleiterbauteil 1 der Figur 3N ist in Figur 3O zu sehen. Die drei Halbleitersäulen 2 sind linear angeordnet. Abweichend von der Darstellung in Figur 3O kann in Draufsicht gesehen auch eine dreieckige Anordnung der Halbleitersäulen 2 vorliegen. Weiterhin ist es möglich, dass auch nur zwei der Halbleitersäulen 2 oder mehr als drei Halbleitersäulen 2 in dem Halbleiterbauteil 1 fest miteinander verbunden vorliegen.

Das Halbleiterbauteil 1 der Figur 3P entspricht im Wesentlichen dem der Figur 3M, wobei die p-Kontaktfläche 35 strahlungsdurchlässig gestaltet ist und die n-Kontaktfläche 45 reflektierend ausgeführt ist. Damit erfolgt eine Emission M über die Spitze 28 und nicht über den Basisbereich 27. Zur Verkapselung insbesondere der aktiven Schicht 22 ist, wie auch in Figur 3M, bevorzugt die Maskenschicht 6 als Passivierung noch vorhanden.

Wie auch in Figur 3M sind in Figur 3P möglich die Kontaktflächen 35, 45 bevorzugt formschlüssig an die Bestromungshülle 24, den Vergusskörper 5 und/oder die Maskenschicht 6 angeformt. Insofern sind die Darstellungen der Figuren 3M und 3P schematisch zu verstehen.

Entsprechend der Figur 3N ist in Figur 3Q dargestellt, dass mehrere der Halbleitersäulen 2 aus Figur 3P zu einer Einheit zusammengefasst sind. Um die Halbleitersäulen 2 elektrisch unabhängig voneinander betreiben zu können ist es möglich, dass die Bestromungshüllen 24 zwischen benachbarten Halbleitersäulen 2 unterbrochen sind, sodass keine durchgehende elektrische Verbindung zwischen benachbarten Halbleitersäulen 2 gegeben ist. Entsprechendes gilt für Figur 3N.

In den Figuren 3R und 3S sind schematische Draufsichten auf die Halbleiterbauteile 1 etwa der Figuren 3N oder 3Q oder auch auf Halbleiterdisplays 10 illustriert. Dabei ist gezeigt, dass die Kontaktflächen 35 neben den Halbleitersäulen 2 angebracht sind.

Gemäß Figur 3R ist jeder der Halbleitersäulen 2 eine eigene Kontaktfläche 35 zugeordnet, sodass die Halbleitersäulen 2 elektrisch unabhängig betreibbar sind. Dagegen liegen in Figur 3S zwei Reihen von Halbleitersäulen 2 vor, wobei jeweils eine Halbleitersäule 2 aus jeder der Reihen mit einer der Kontaktflächen 35 verbunden ist.

Damit sind jeweils zwei der Halbleitersäulen elektrisch parallel geschaltet, angedeutet durch das schematische Schaltbild in Figur 3S. Somit lässt sich eine redundante Anordnung der Halbleitersäulen 2 erzielen. Eine der in Figur 3S entsprechende Parallelschaltung von Halbleitersäulen 2 kann auch in allen anderen Ausführungsbeispielen der Halbleiterbauteile 1 sowie der Halbleiterdisplays 10 vorliegen. Das heißt, es können jeweils kleine Gruppen von Halbleitersäulen 2 redundant zu einer elektrischen Einheit zusammengefasst werden.

Bevorzugt sind in den Halbleiterbauteilen der Figuren 3N und 3Q zusätzlich nicht gezeichnete Leuchtstoffe vorhanden. Damit sind diese Halbleiterbauteile 1 bevorzugt als RGB-Einheiten einsetzbar. Mit solchen Halbleiterbauteilen 1, wie etwa in den Figuren 3M, 3N, 3O, 3P und/oder 3Q dargestellt, lassen sich insbesondere Pixelsegmente realisieren, die etwa zu einer Videowand oder auch zu Mikrodisplays oder anderen Displays zusammengesetzt werden können.

Auch mit dem Verfahren der Figur 3 und dem in diesen Zusammenhang beschriebenen Halbleiterbauteilen 1 und Halbleiterdisplays 10 ist eine sehr hohe Dichte von Halbleitersäulen pro Flächeneinheit realisierbar, beispielsweise mindestens 10⁴ oder 10⁵ oder 10⁶ Halbleitersäulen pro mm². Diese hohe Flächendichte an Halbleitersäulen 2 liegt insbesondere unmittelbar an dem Aufwachssubstrat 20 vor.

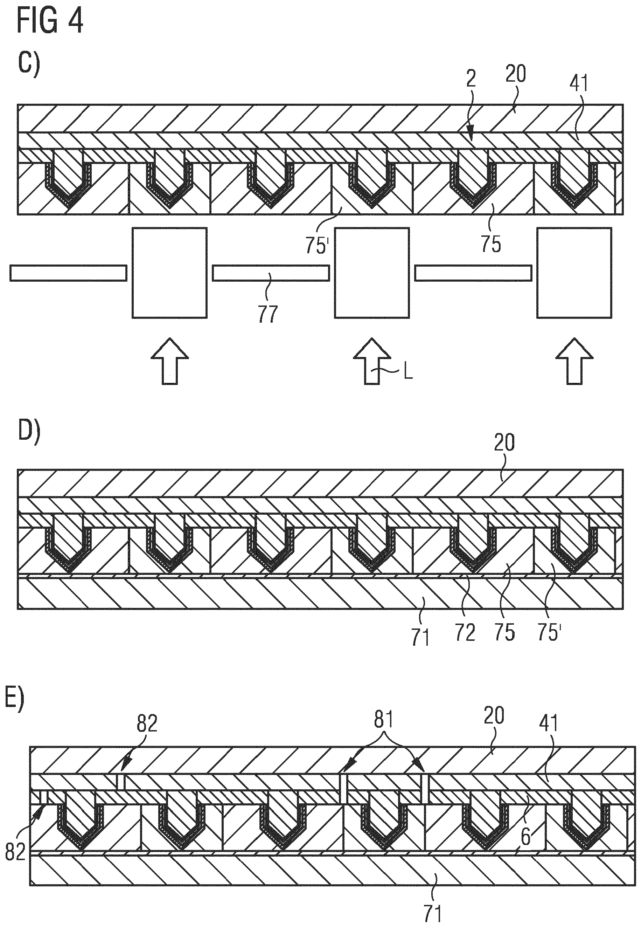

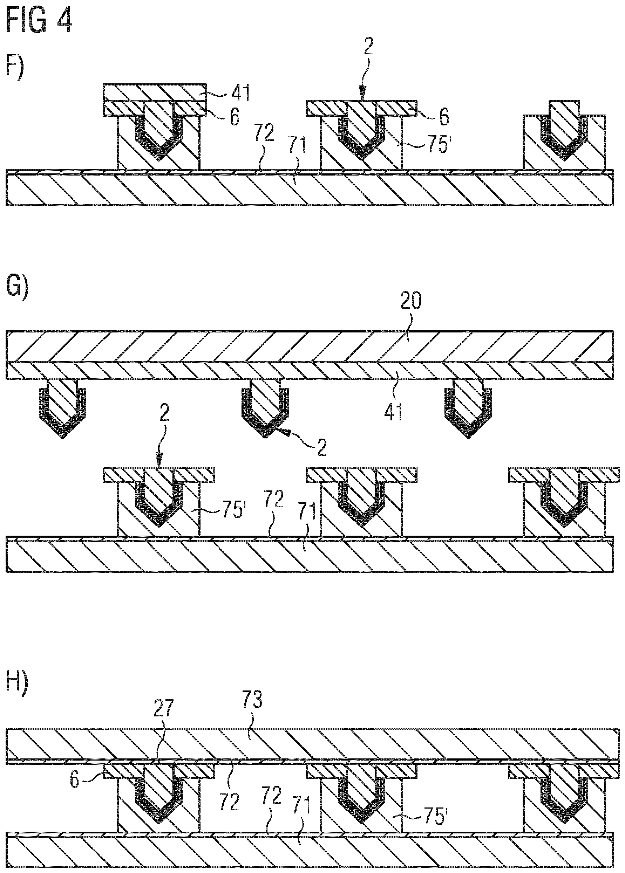

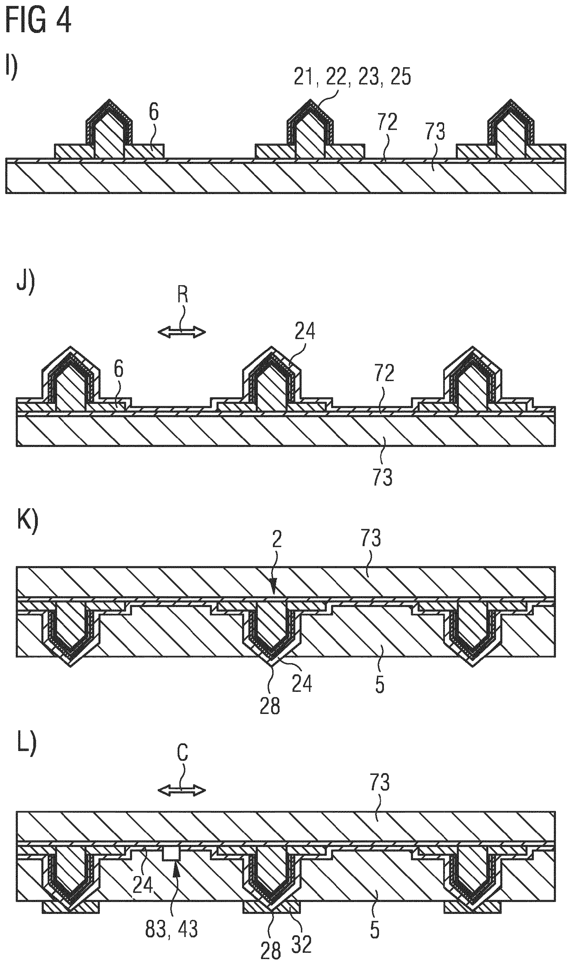

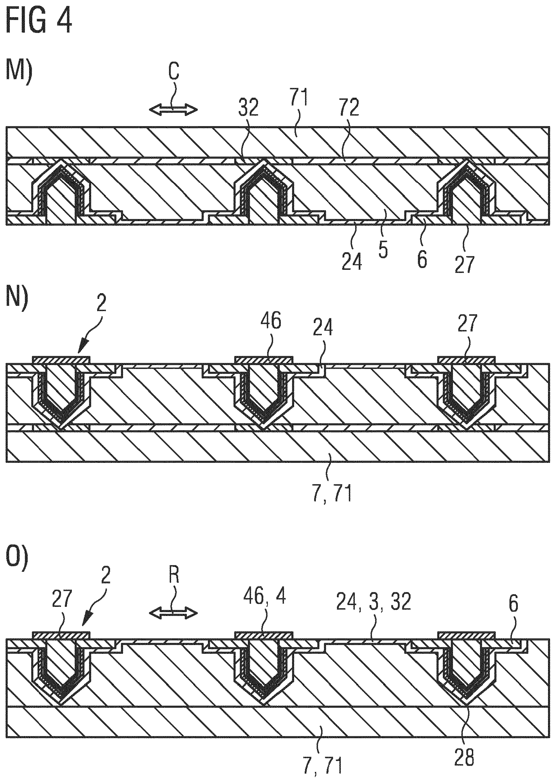

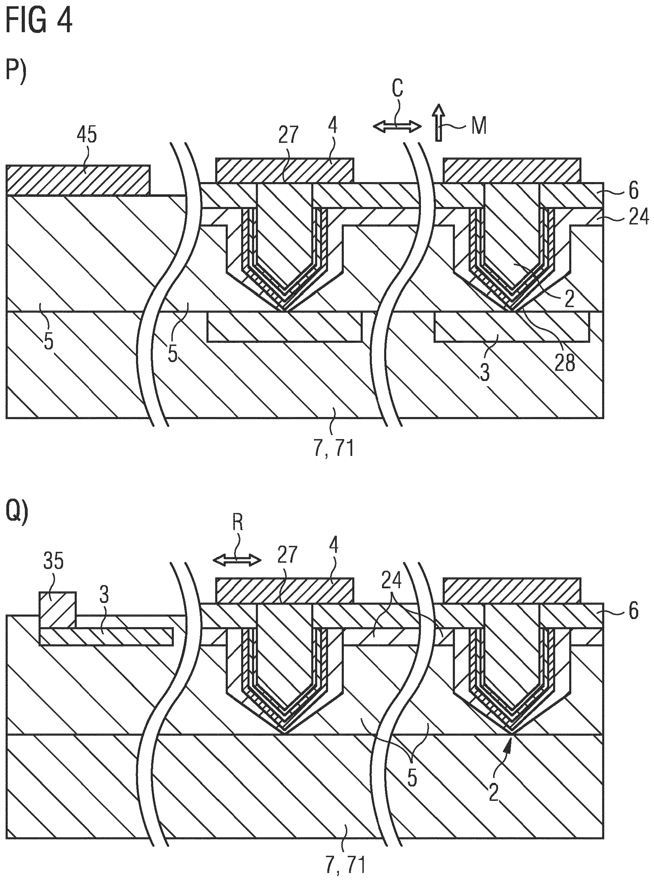

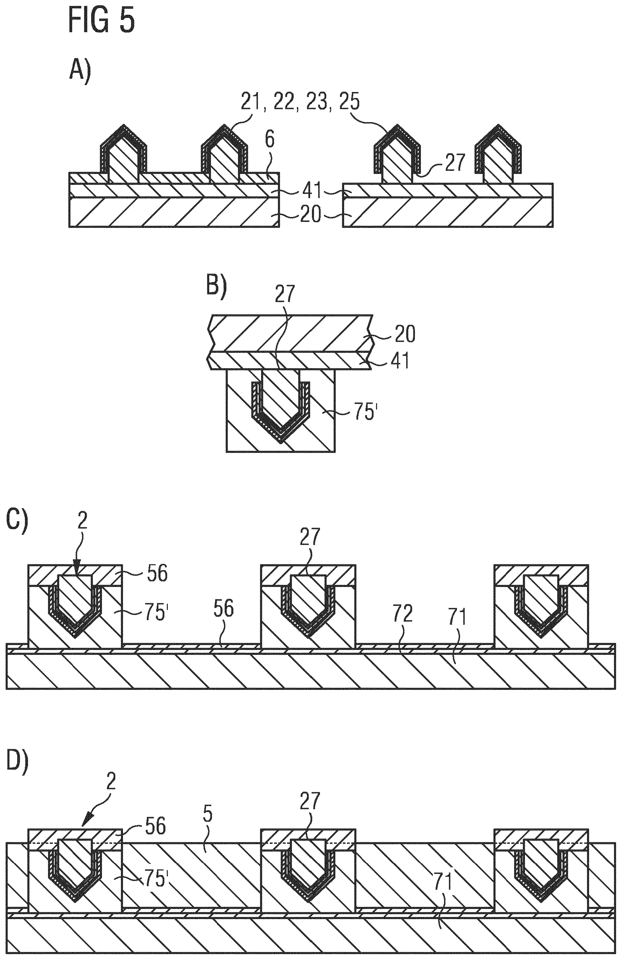

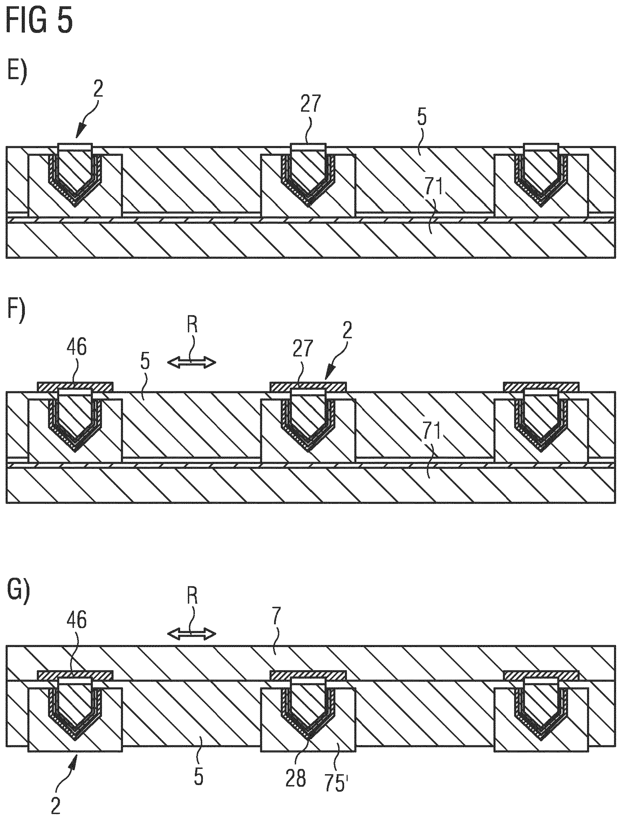

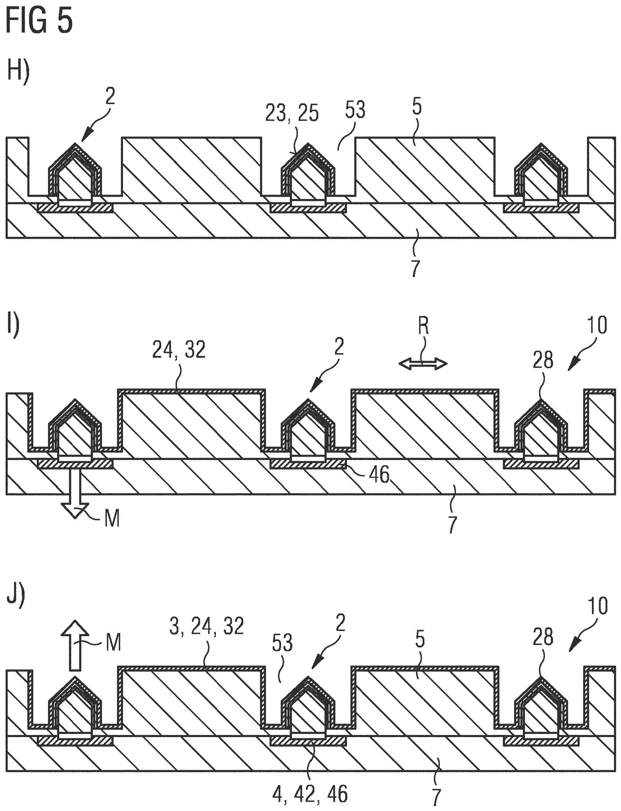

Mit dem nachfolgend beschriebenen Verfahren der Figuren 4 und 5 ist es möglich, die Flächendichte der Halbleitersäulen 2 im fertigen Halbleiterdisplay 10 und/oder in den fertigen Halbleiterbauteilen 1 gegenüber der Flächendichte am Aufwachssubstrat 20 zu reduzieren. Hierdurch lassen sich praktikable Abstände zwischen den Halbleitersäulen 2 in den fertigen Bauteilen 1, 10 erzeugen, bei gleichzeitig einer effizienten, kostensparenden Fertigung der Halbleitersäulen 2 am jeweiligen Aufwachssubstrat 20.

Gemäß der Schnittdarstellung in Figur 4A werden die Halbleiterkerne 21, die aktiven Schichten 22, die Halbleiterhüllen 23 sowie die optionalen Zusatzschichten 25 in einer vergleichsweise dichten Anordnung aus den Öffnungen 61 der Maskenschicht 6 heraus gewachsen, beginnend von der n-dotierten Halbleiterschicht 41 an dem Aufwachssubstrat 20.

Nachfolgend, siehe Figur 4B, werden die Halbleitersäulen 2 in eine Transfermatrix 75 eingebracht. Die Transfermatrix 75 ist bevorzugt aus einem vernetzbaren Polymer gebildet. Im Schritt der Figur 4B weist die Transfermatrix 75 eine vergleichsweise niedrige Viskosität auf und ist flüssig.

Im Schritt der Figur 4C wird eine Maske 77 angebracht und über eine Belichtung mit einer Strahlung L werden ausgehärtete Bereiche 75' in der Transfermatrix 75 erzeugt. Damit werden ausgewählte Halbleitersäulen 2 in die ausgehärteten Bereiche 75' fest eingebettet.

Daraufhin wird, siehe Figur 4D, ein Hilfsträger 71 über ein temporäres Verbindungsmittel 72 angebracht, das zum Beispiel ein Klebstoff ist. Abweichend von der Darstellung in Figur 4D ist es möglich, dass das flüssige Material der Transfermatrix 75 bereits entfernt ist, sodass nur die ausgehärteten Bereiche 75' verblieben sein können.

Alternativ zu den Verfahrensschritten der Figuren 4B und 4C ist es möglich, dass ein vergleichsweises zähes Material für die Transfermatrix 75 nur über manchen der Halbleitersäulen 2 angebracht wird, sodass nur ausgewählte Halbleitersäulen 2 in die Transfermatrix 75 eingedrückt werden. Diese in die Transfermatrix 75 eingedrückten Halbleitersäulen entsprechen den in Figur 4D dann sich in den ausgehärten Bereichen 75' befindlichen Halbleitersäulen 2.

Im optionalen Schritt der Figur 4E werden Unterbrechungen 81, 82 erstellt. Die ersten Unterbrechungen 81 reichen durch die n-leitende Halbleiterschicht 41 und die Maskenschicht 6 hindurch. Die zweiten Unterbrechungen 82 sind entweder auf die Maskenschicht 6 oder auf die n-leitende Halbleiterschicht 41 begrenzt. Es ist möglich, dass das Erzeugen der Unterbrechungen 81, 82 auch bereits im Verfahrensschritt der Figur 4A erfolgt ist.

In Figur 4F ist gezeigt, dass das Aufwachssubstrat 20 etwa über ein Laserabhebeverfahren entfernt wird. Das Entfernen vom Aufwachssubstrat 20 kann derart durchgeführt werden, dass entweder die Maskenschicht 6 zusammen mit der n-leitenden Schicht 41 an den Halbleitersäulen 2 in den ausgehärten Bereichen 75' verbleibt, siehe die in Figur 4F links angeordnete Halbleitersäule. Alternativ ist es möglich, dass nur die Maskenschicht 6, nicht aber die n-leitende Halbleiterschicht 41, an den Halbleitersäulen 2 verbleibt, siehe den mittleren Bereich in Figur 4F. Außerdem können sowohl die n-leitende Halbleiterschicht 41 als auch die Maskenschicht 6 beim Ablösen vom Aufwachssubstrat 20 von den Halbleitersäulen 2 entfernt werden, siehe die Konfiguration rechts in Figur 4F.

Damit wird, siehe Figur 4G, lediglich ein Teil der Halbleitersäulen 2 vom Aufwachssubstrat 20 abgelöst. Über den Anteil und den Abstand der vom Aufwachssubstrat 20 abgelösten Halbleitersäulen 2 lässt sich die Flächendichte an dem Hilfsträger 71 und damit in dem späteren Display 10 oder Halbleiterbauteil 1 einstellen. Die an dem Aufwachssubstrat 20 verbliebenen Halbleitersäulen 2 werden in späteren Prozessschritten analog zu den Figuren 4B bis 4F auf einen anderen Hilfsträger 71 und/oder permanenten Träger 7 transferiert.

In Figur 4H ist illustriert, dass über ein weiteres temporäres Verbindungsmittel 72 ein Zwischenträger 73 an den Basisbereichen 27 sowie optional den übriggebliebenen Bereichen der Maskenschicht 6 und/oder der n-leitenden Halbleiterschicht 41 angebracht wird.

Daraufhin wird, siehe Figur 4I, der Hilfsträger 71 entfernt und die Halbleitersäulen 2 verbleiben an dem Zwischenträger 73.

Nachfolgend werden, siehe Figur 4J, die Bestromungshüllen 24 durchgehend als Kontaktstege 32 entlang der Zeilen R hergestellt. Dabei werden die Bestromungshüllen 24 unmittelbar auf die Halbleitermaterialien der Halbleitersäulen 2 und optional die verbliebenen Bereiche der Maskenschicht 6 und/oder der n-leitenden Halbleiterschicht 41 sowie das Verbindungsmittel 72 aufgebracht. Das Aufbringen der Bestromungshüllen 24 erfolgt bevorzugt in mehreren Streifen, sodass die Kontaktstege 32 für die Zeilen R gebildet werden.

Nachfolgend wird, siehe Figur 4K, der Vergusskörper 5 erzeugt. Der Vergusskörper 5 wird direkt auf die Bestromungshüllen 24 aufgebracht und umformt diese unmittelbar. Dabei bleiben die Spitzen 28 der Halbleitersäulen 2 bevorzugt frei von dem Vergusskörper 5.

Gemäß Figur 4L werden die Kontaktstege 32 an den Spitzen 28 angebracht. Die Kontaktstege 32 können senkrecht zur Zeichenebene der Figur 4L zeilenweise verlaufen. Bevorzugt sind die Kontaktstege 32 reflektierend für die im Betrieb erzeugte Strahlung.

Optional ist es möglich, dass zwischen benachbarten Zeilen R Unterbrechungen 83 in die Bestromungshüllen 24 gefertigt werden. Hierdurch lassen sich benachbarte Zeilen R elektrisch effizient voneinander trennen.

Beim Verfahrensschritt, wie in der Schnittdarstellung der Figur 4M gezeigt, wird auf den Vergusskörper 5 und die Kontaktstege 32 der Hilfsträger 71 mit dem temporären Verbindungsmittel 72 aufgebracht. Ferner wurde der Zwischenträger 73 entfernt, sodass die Basisbereiche 27, die verbleibenden Bereiche der Maskenschicht 6 und optional der n-leitenden Halbleiterschicht 41 sowie die Bestromungshüllen 24 freigelegt werden. Es ist möglich, dass das Verbindungsmittel 72 auf Bereiche zwischen benachbarten Kontaktstegen 32 beschränkt ist. Damit können die Kontaktstege 32 in unmittelbarem Kontakt zu dem Hilfsträger 71 stehen.

Gemäß Figur 4N werden die Stromschienen 46 an den Basisbereichen 27 angebracht. Ferner folgt bevorzugt eine bereichsweise Entfernung des Materials der Bestromungshüllen 24, sodass benachbarte Zeilen R elektrisch nicht mehr miteinander verbunden sind.

Optional ist es möglich, dass der Hilfsträger 71 durch einen permanenten Träger 7 ersetzt wird. Bei dem Träger 7 handelt es sich beispielsweise um ein Submount, das elektronische Komponenten wie Transistoren zur Ansteuerung der Halbleitersäulen 2 beinhalten kann.

In Figur 4O ist eine alternative Möglichkeit zur Führung der Kontaktleisten 3, 4 illustriert. Entlang der Zeilen R erfolgt eine durchgehende elektrische Verbindung über die Bestromungshüllen 24, die gleichzeitig die Kontaktstege 32 bilden. In diesem Fall sind die Bestromungshüllen 24 bevorzugt aus einem reflektierenden Metall wie Silber.

Die Stromschienen 46 der zweiten Bestromungsleisten 4 verlaufen senkrecht zur Zeichenebene der Figur 4O und sind bevorzugt aus einem transparenten leitfähigen Material wie ITO. Zusätzlich können nicht gezeichnete Stromschienen aus einem Metall vorhanden sein, die bevorzugt neben den Halbleitersäulen 2 angeordnet sind, um diese möglichst wenig zu verdecken. Dabei sind die Stromschienen 46 auf die verbleibenden Gebiete der Maskenschicht 6 begrenzt, um Kurzschlüsse hin zu den ersten Kontaktleisten 3 zu vermeiden. Damit ist keine Umverdrahtungsebene am Träger 7 im Bereich der Spitzen 28 erforderlich.

Die beiden Kontaktierungsschemata sind in den Schnittdarstellungen der Figuren 4P und 4Q nochmals zusammenfassend illustriert. Gemäß Figur 4P erfolgt eine Ansteuerung der Halbleitersäulen 2 über die an den Spitzen 28 liegenden ersten Kontaktleisten 3 und über die an den Basisbereichen 27 verlaufenden zweiten Kontaktleisten 4. Somit sind die Halbleitersäulen 2 entlang der Hauptemissionsrichtung M zwischen den Kontaktleisten 3, 4 angebracht.

Demgegenüber verlaufen die Kontaktleisten 3, 4 gemäß Figur 4Q allesamt an der Seite der Basisbereiche 27 der Halbleitersäulen 2.

Über nicht gezeichnete Durchkontaktierungen ist es möglich, dass die Kontaktflächen 35, 45 sowohl in Figur 4P als auch in Figur 4Q an den Träger 7 oder an die den Basisbereichen 27 abgewandte Seite des Hilfsträgers 71 hingeführt werden. Damit können sich alle Kontaktflächen 35, 45 an einer der Hauptemissionsrichtung M entgegengesetzten Seite der Halbleitersäulen 2 befinden.

Beim Verfahren der Figur 5 erfolgt das Ablösen der Halbleitersäulen 2 von dem Aufwachssubstrat 20 über Sollbruchstellen. Solche Sollbruchstellen können auch als vertikaler Tether bezeichnet werden. Dabei werden die Halbleitersäulen 2 gemäß der Schnittdarstellung in Figur 5A, linke Seite, gewachsen, wie in Verbindung mit den übrigen Ausführungsbeispielen erläutert.

Anschließend wird die Maskenschicht 6, siehe Figur 5A, rechte Hälfte, von allen oder von den im nächsten Schritt abzulösenden Halbleitersäulen 2 entfernt. Damit ist es möglich, dass eine Verschmälerung der Halbleitersäulen 2 an der n-leitenden Halbleiterschicht 41 vorliegt. Durch diese Verschmälerung sind die Sollbruchstellen realisierbar.

In Figur 5B ist illustriert, dass ein ausgehärteter Bereich 75' der Transfermatrix 75 über bestimmte Halbleitersäulen 2 gestülpt wird. Dies kann erfolgen, wie in Verbindung mit Figur 4 erläutert. Alternativ ist es möglich, dass eine Einstempelung von bestimmten Halbleitersäulen 2 in ein thermoplastisches Material für die Transfermatrix 75 erfolgt, auch als Hot Embossing bezeichnet. In diesem Fall kann eine Belichtung, wie in Figur 4C durchgeführt, entfallen. Entsprechende Bereiche 75' können alternativ auch über ein Druckverfahren um einzelne Halbleitersäulen 2 herum erzeugt werden.

Dabei ist es optional möglich, dass der ausgehärtete Bereich 75' in die Verschmälerung der Halbleitersäulen 2 nahe der n-leitenden Halbleiterschicht 41 eingreift, wie in Figur 5B dargestellt. Durch dieses Eingreifen in die Verschmälerung ist ein Ablösen von ausgewählten Halbleitersäulen 2 vom Aufwachssubstrat 20 und von der n-leitenden Halbleiterschicht 41 vereinfacht. Alternativ erfolgt kein derartiges Eingreifen in die Verschmälerung.

Im optionalen Verfahrensschritt der Figur 5C wird eine Passivierungsschicht 56 unstrukturiert und ganzflächig aufgebracht, insbesondere mit einem gerichteten Verfahren. Damit werden die ausgehärteten Bereiche 75' sowie die Basisbereiche 57 von der Passivierschicht 56 bedeckt.

In Figur 5D ist illustriert, dass der Vergusskörper 5 erzeugt wird. Der Vergusskörper 5 kann dabei an den Basisbereichen 27 optional bis an die Halbleitermaterialien der Halbleitersäulen 2 herangeführt werden und sich damit zwischen die Passivierungsschicht 56 und die ausgehärteten Bereiche 75' erstrecken. Alternativ bleiben dem Hilfsträger 71 abgewandte Seiten der ausgehärteten Bereiche 75' völlig frei von dem Vergusskörper 5, sodass diese Seiten der ausgehärteten Bereiche 75' lediglich von der Passivierungsschicht 56 bedeckt bleiben.

In Figur 5E ist illustriert, dass die Passivierungsschicht 56 entfernt ist, sodass die dem Hilfsträger 71 abgewandte Seite der Anordnung durch den Vergusskörper 5 zusammen mit den Basisbereichen 27 gebildet wird.

In Figur 5F ist gezeigt, dass auf die Basisbereiche 27 die Stromschienen 46 für die Spalten C aufgebracht werden. Anschließend, siehe Figur 5G, können die Stromschienen 46 mit dem insbesondere permanenten Träger 7 verbunden werden. Die Spitzen 28 weisen dabei weg von dem optionalen Träger 7.

Im optionalen Verfahrensschritt der Figur 5H werden die ausgehärteten Bereiche 75' der Transfermatrix entfernt, sodass Ausnehmungen 53 in dem Vergusskörper 5 verbleiben, in denen sich je eine der Halbleitersäulen 2 befindet. Die Ausnehmungen 53 weisen damit im Querschnitt gesehen eine andere Form auf als die Halbleitersäulen 2.

Alternativ ist es möglich, dass die Bereiche 75' in den fertigen Halbleiterbauteilen 10 verbleiben. Dabei können die Bereiche 75', die dann bevorzugt aus einem lichtdurchlässigen Material gebildet sind, als Optiken Verwendung finden.

Weiterhin können solche verbleibenden Bereiche 75' auch mit Leuchtstoffen versehen sein, um eine Konversion der in den Halbleitersäulen 2 erzeugten Primärstrahlung zu bewirken.

Im Verfahrensschritt der Figur 5I werden die Bestromungshüllen 24 angebracht, die auch als Stromstege 32 entlang der Zeilen R fungieren. Dabei sind die Bestromungshüllen 24 bevorzugt aus einem reflektierenden Material. Die Stromschienen 46 sind zumindest größtenteils lichtdurchlässig, sodass eine Emission M durch den optionalen Träger 7 hindurch in Richtung weg von den Spitzen 28 erfolgt.

Demgegenüber sind die Stromschienen 46 in Figur 5J als Spiegel 42 gestaltet und die Bestromungshüllen 24 sind lichtdurchlässig. Somit erfolgt die Emission M in Richtung weg von dem optionalen Träger 7 über die Spitzen 28. In diesem Fall ist der Vergusskörper 5 bevorzugt aus einem reflektierenden Material wie einem mit Titandioxidpartikeln gefüllten Silikon, um die erzeugte Strahlung etwa diffus oder alternativ auch spekular zu reflektieren.

In den fertigen Halbleiterbauteilen 10 liegt ein Abstand zwischen benachbarten Halbleitersäulen 2 im Bereich von mehreren Mikrometern bis hin zu Millimetern. Dies ist über die Abstandsexpansion mit Hilfe des sequentiellen Ablösens jeweils eines Teils der Halbleitersäulen 2 vom Aufwachssubstrat 20 ermöglicht, wie in den Figuren 4 und 5 illustriert. Dagegen weisen die Halbleitersäulen 2 in den fertigen Bauteilen 1, 10 im Querschnitt gesehen bevorzugt erheblich kleinere laterale Abmessungen etwa im Bereich von 0,5 µm bis 2 µm auf, wohingegen ein Abstand zwischen benachbarten Halbleitersäulen 2 in lateraler Richtung bevorzugt bei mindestens 10 µm oder 30 µm und/oder bei höchstens 200 µm oder 50 µm liegt. Entsprechendes kann auch in allen anderen Ausführungsbeispielen gelten.

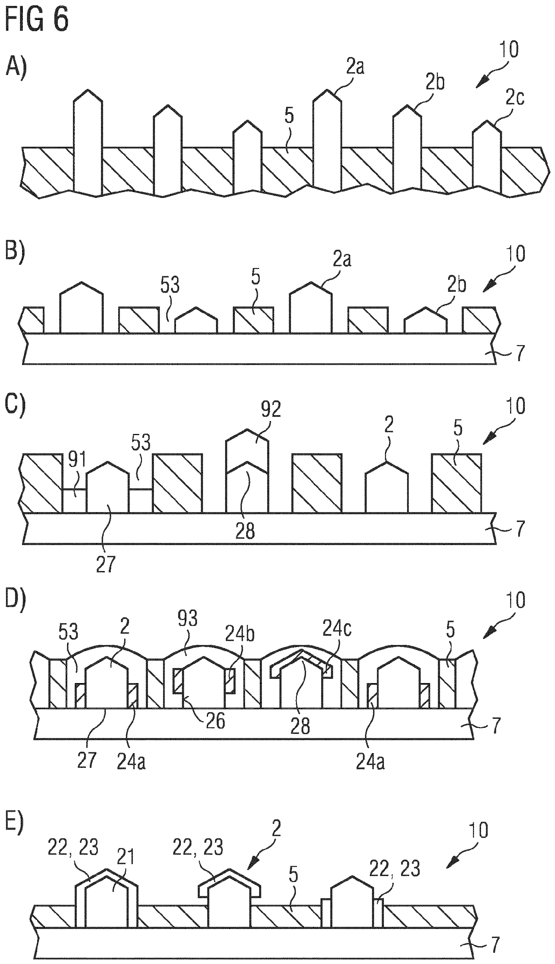

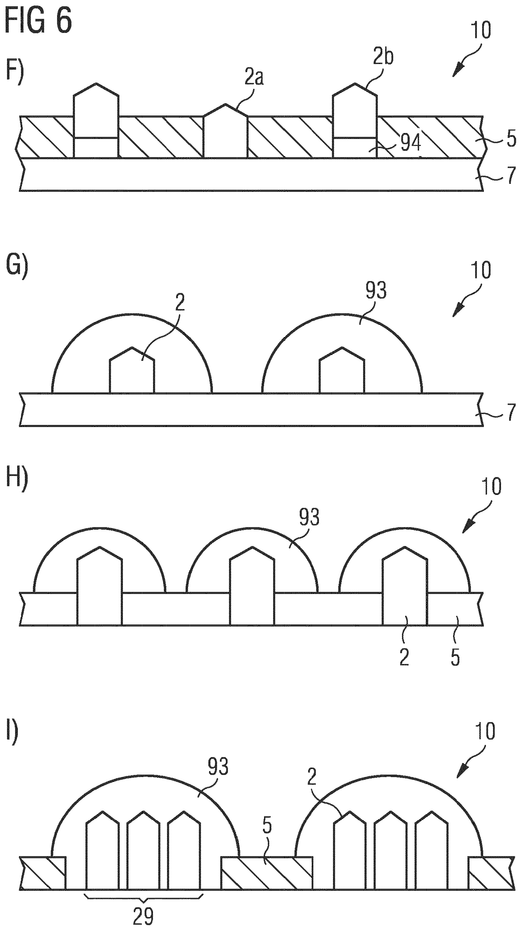

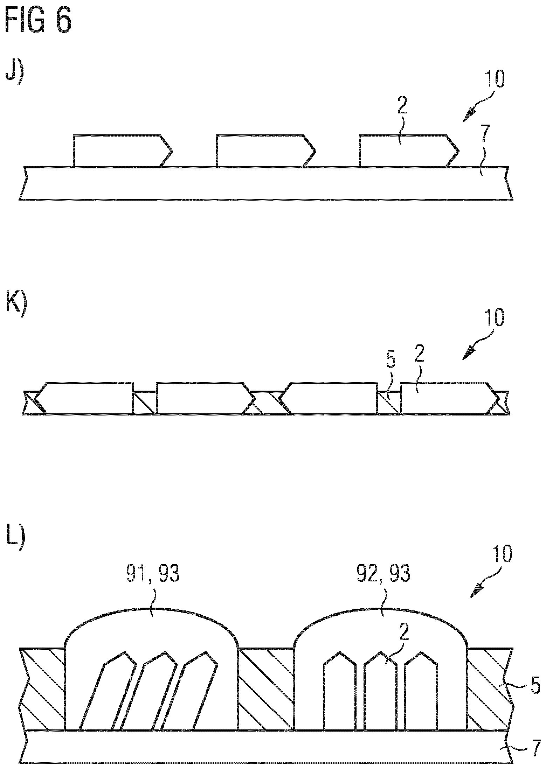

In Figur 6 sind weitere Ausführungsbeispiele der Halbleiterdisplays 10 gezeigt, die analog für die Halbleiterbauteile 1 gelten können. Dabei sind nur die jeweils für die Illustration wesentlichen Komponenten gezeichnet, sodass insbesondere die Kontaktleitungen 3, 4 und der eventuell vorliegende Isolierkörper 55 jeweils nicht dargestellt sind. Die gezeigten Varianten lassen sich entsprechend auf die jeweils übrigen Ausführungsbeispiele übertragen.

Bei den Halbleiterdisplays 10 der Figuren 6A bis 6F erfolgt mittels der Halbleitersäulen 2 mindestens zum Teil eine winkelabhängige Abstrahlung. Dadurch kann zum Beispiel ein 3D-Display erreicht werden oder es können etwa zu einer Entblendung bestimmte Winkelbereiche abgedunkelt oder besonders intensiv beleuchtet werden.

Dazu weisen die Halbleitersäulen 2a, 2b, 2c gemäß Figur 6A unterschiedliche Höhen über dem Vergusskörper 5 auf. Abweichend von Figur 6A können auch nur zwei oder mehr als drei Arten verschiedener Halbleitersäulen 2a, 2b, 2c vorliegen.

In Figur 6B ist gezeigt, dass die Halbleitersäulen 2a, 2b verschiedene Höhen sowohl über dem Träger 7 als auch über dem Vergusskörper 5 aufweisen. Es ist möglich, dass eine Dicke des Vergusskörpers 5 zwischen den Höhen der beispielsweise zwei Arten von Halbleitersäulen 2a, 2b liegt.

In Figur 6C ist illustriert, dass die Winkelabhängigkeit der Abstrahlung durch verschiedene Anordnungen der Leuchtstoffschichten 91, 92 erzielt wird. Beispielsweise füllt eine Leuchtstoffschicht 91 die Ausnehmungen 53 vom Träger 7 her auf, wohingegen eine andere Art von Leuchtstoffschichten 93 auf den Spitzen 28 angebracht ist. Alternativ könnten unterschiedliche Füllhöhen vom Träger 7 her vorliegen.

Beim Ausführungsbeispiel der Figur 6D sind die Bestromungshüllen 24a, 24b, 24c auf unterschiedlichen Bereichen der Halbleitermaterialien der Halbleitersäulen 2 angebracht, etwa nur an den Basisbereichen 27, nur in den Mitten der Halbleitersäulen 2 an den Seitenflächen 26 oder nur an den Spitzen 28. Durch die insbesondere metallischen, lichtundurchlässigen Bestromungshüllen 24a, 24b, 24c ist die Abstrahlcharakteristik einstellbar. Zudem kann eine Variation einer Bestromung, insbesondere eine Teilbestromung, der Halbleitersäulen 2 erreicht werden.

Optional können die Ausnehmungen 53 mit einer Füllung 93 versehen sein, die bevorzugt als Optik, etwa als Anordnung von den Halbleitersäulen 2 einzeln zugeordneten Sammellinsen, ausgeführt ist.

Bei den Anordnungen insbesondere der Figuren 6C und 6D kann der Träger 7 auch weggelassen werden, etwa falls die Ausnehmungen 53 mit der bevorzugt transparenten Füllung 93 versehen sind und durch die Füllung 93 zusammen mit dem Vergusskörper 5, oder alternativ zusammen mit dem Isolierkörper oder den Kontakflächen, vergleiche etwa Figur 1J, eine ausreichende mechanische Stabilität erreicht wird.

Gemäß Figur 2E erfolgt eine Deaktivierung von Teilbereichen der Halbleitersäulen 2. So ist die aktive Schicht 22 teilweise entfernt.

Dagegen sind die Halbleitersäulen 2a, 2b gemäß Figur 6F zwar gleich lang, jedoch zum Teil auf Sockeln 94 aufgebracht, sodass die Halbleitersäulen 2a, 2b den etwa reflektierenden Vergusskörper 5 unterschiedlich weit überragen.

In den Figuren 6G bis 6I sind unterschiedliche Konfigurationen der als Optik gestalteten Füllung 93 illustriert, die entsprechend auch in allen anderen Ausführungsbeispielen vorliegen können. Gemäß Figur 6G sind die Halbleitersäulen 2 einzeln von der halbkugelförmigen Füllung 93 überdeckt.

Eine ähnliche Anordnung findet sich in Figur 6H, wobei jedoch die Füllung 93 auf dem Vergusskörper 5 aufgebracht ist. Die Ausnehmungen im Vergusskörper 5 sind vollständig von den Halbleitersäulen 2 selbst ausgefüllt.

Demgegenüber erstreckt sich die Füllung 93 in Figur 6I zusammenhängend und kuppelförmig über mehrere der Halbleitersäulen 2. Damit kann die Strahlung dieser Halbleitersäulen 2 vereinigt werden, sodass sich ein zusammenhängender Abstrahlbereich und/oder Lichtpunkt pro Füllung 93 ergibt. Somit kann eine Menge von transparent kontaktiertbaren Halbleitersäulen 2 in einer transparenten Füllung 93 als strahlformendes Material angebracht sein, die diese zu einem Pixel vereint. Die Halbleitersäulen 2 strahlen bevorzugt allseitig ab, die Abstrahlung wird durch die Füllung 93 geformt.

In den Figuren 6J bis 6L sind die Halbleitersäulen 2 nicht stehend angeordnet, sondern liegend oder quer. Dabei befinden sich die Halbleitersäulen 2 gemäß Figur 6J auf dem Träger 7. In Figur 6K sind die Halbleitersäulen 2 in dem zum Beispiel reflektierenden oder auch lichtdurchlässigen Vergusskörper 5 untergebracht.

Beim Ausführungsbeispiel der Figur 6L liegen mehrere Gruppen 29 vor. Innerhalb einer Gruppe 29 sind die Halbleitersäulen 2 gleich oder näherungsweise gleich orientiert. Die Halbleitersäulen 2 unterschiedlicher Gruppen 29 können verschieden zueinander ausgerichtet sein.

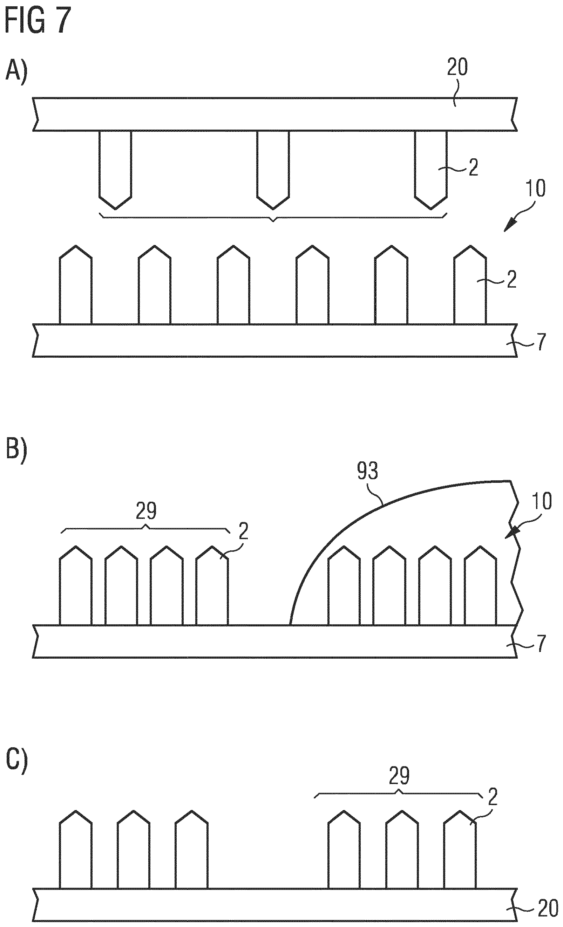

Bei den Verfahren der Figur 7 erfolgt, anders als in den Figuren 4 und 5, keine Expansion, sondern durch den Transfer vom Aufwachssubstrat 20 weg eine Flächenkomprimierung der Halbleitersäulen 2 etwa zur Erhöhung der Leuchtdichte. So kann die Flächendichte der Halbleitersäulen 2 nach dem Transfer etwa auf den Träger 7 zum Beispiel um einen Faktor 2 erhöht sein, siehe die Prinzipskizze in Figur 7A.

Zum Beispiel können die Halbleitersäulen 2 auf mehr als 10 pro Quadratmikrometer komprimiert werden, wobei Einzelflächen der Halbleitersäulen 2 beispielsweise im Bereich von 0,3 x 0,3 µm² = 0,09 µm² liegen.

Dabei können mehrere eng angeordnete Halbleitersäulen 2 in einer Gruppe 29 zusammengefasst werden, die gemeinsam als Pixel oder Bildpunkt oder Farbbereich eines Bildpunkts dienen, siehe Figur 7B. Der Abstand zwischen den Gruppen 29 kann deutlich größer sein als zwischen den Halbleitersäulen 2 innerhalb der Gruppen 29.

In Figur 7C ist illustriert, dass die Halbleitersäulen 2 bereits auf dem Aufwachssubstrat 20 wie später gewünscht räumlich verteilt gewachsen werden. So kann schon am Aufwachssubstrat 20 eine Gruppierung der Halbleitersäulen 2 durchgeführt werden, die derart oder auch expandiert oder komprimiert auf einen nicht gezeichneten Träger oder Vergusskörper übertragbar ist.

Die in den Figuren gezeigten Komponenten folgen, sofern nicht anders kenntlich gemacht, bevorzugt in der angegebenen Reihenfolge jeweils unmittelbar aufeinander. Sich in den Figuren nicht berührende Schichten sind bevorzugt voneinander beabstandet. Soweit Linien parallel zueinander gezeichnet sind, sind die entsprechenden Flächen bevorzugt ebenso parallel zueinander ausgerichtet. Ebenfalls, soweit nicht anders kenntlich gemacht, sind die relativen Positionen der gezeichneten Komponenten zueinander in den Figuren korrekt wiedergegeben.

Diese Patentanmeldung beansprucht die Priorität der deutschen Patentanmeldung 10 2017 113 745. 9.

### Bezugszeichenliste

- 1: optoelektronisches Halbleiterbauteil
- 2: Halbleitersäule
- 20: Aufwachssubstrat
- 21: Halbleiterkern
- 22: aktive Schicht
- 23: Halbleiterhülle
- 24: Bestromungshülle
- 25: Zusatzschicht
- 26: Seitenfläche
- 27: Basisbereich
- 28: Spitze
- 29: Gruppe von Halbleitersäulen
- 3: erste elektrische Kontaktleiste (Zeilenkontaktierung)
- 31: Durchkontaktierung
- 32: metallischer oder TCO-Kontaktsteg
- 35: erste elektrische Kontaktfläche
- 4: zweite elektrische Kontaktleiste (Spaltenkontaktierung)
- 41: n-leitende Halbleiterschicht
- 42: Spiegel
- 43: elektrische Durchkontaktierung
- 44: transparente leitfähige Schicht
- 45: zweite elektrische Kontaktfläche
- 46: metallische oder TCO-Stromschiene
- 47: Pufferschicht
- 5: Vergusskörper
- 51: erste Hauptseite des Vergusskörpers
- 52: zweite Hauptseite des Vergusskörpers
- 53: Ausnehmung
- 55: Isolierkörper
- 56: Passivierschicht
- 6: Maskenschicht
- 61: Öffnung
- 7: Träger
- 71: Hilfsträger
- 72: temporäres Verbindungsmittel
- 73: Zwischenträger
- 74: Randschutz
- 75: Transfermatrix
- 77: Maske
- 81: Unterbrechung
- 82: Unterbrechung
- 83: Unterbrechung
- 91: erste Leuchtstoffschicht (etwa für rotes Licht)
- 92: zweite Leuchtstoffschicht (etwa für grünes Licht)
- 93: Füllung (Optik, Linse)
- 94: Sockel
- 10: Halbleiterdisplay
- 12: Abstrahlfeld
- M: Hauptemissionsrichtung
- C: Spaltenrichtung
- R: Zeilenrichtung
- L: Belichtung

## Patentansprüche

1. Halbleiterdisplay (10) mit
- einer Vielzahl von Halbleitersäulen (2), und
- ersten und zweiten elektrischen Kontaktleisten (3, 4), und
- mindestens einem für die zu erzeugende Strahlung undurchlässigen Vergusskörper (5),
wobei
- die Halbleitersäulen (2) je einen Halbleiterkern (21) eines ersten Leitfähigkeitstyps und eine Halbleiterhülle (23) eines vom ersten verschiedenen, zweiten Leitfähigkeitstyps aufweisen sowie eine dazwischenliegende aktive Schicht (22) zur Strahlungserzeugung,
- die Halbleitersäulen (2) je eine Bestromungshülle (24) umfassen, die zur Bestromung auf die jeweilige Halbleiterhülle (23) aufgebracht ist, und
- die Halbleitersäulen (2) oder kleine Gruppen (29) von Halbleitersäulen (2) über die ersten und zweiten elektrischen Kontaktleisten (3, 4) unabhängig voneinander ansteuerbar sind und die kleinen Gruppen (29) je höchstens 25 der Halbleitersäulen (2) umfassen, und
- sich die auf AlInGaN basierenden, mindestens 10⁴ Halbleitersäulen (2) in Ausnehmungen (53) des Vergusskörpers (5) befinden.

2. Halbleiterdisplay (10) nach dem vorhergehenden Anspruch, wobei
- mindestens 10⁶ der Halbleitersäulen (2) in den Ausnehmungen (53) des Vergusskörpers (5) angebracht sind,
- ein mittlerer Durchmesser der Halbleitersäulen (2) zwischen einschließlich 40 nm und 5 µm liegt,
- ein Verhältnis aus einer mittleren Höhe der Halbleitersäulen (2) und dem mittleren Durchmesser zwischen einschließlich 0,5 und 3 liegt,
- die Halbleitersäulen (2) hexagonal sind und von einem Basisbereich (27) her gewachsen sind sowie eine dem Basisbereich (27) gegenüberliegende pyramidale Spitze (28) aufweisen,
- die aktive Schicht (22) sich durchgehend über Seitenflächen (26) und die Spitze (28) erstreckt,
- die ersten Kontaktleisten (3) in Draufsicht gesehen senkrecht zu den zweiten Kontaktleisten (4) verlaufen, und
- die kleinen Gruppen (29) von Halbleitersäulen (2) je höchstens 16 der Halbleitersäulen (2) umfassen.

3. Halbleiterdisplay (10) nach einem der vorhergehenden Ansprüche,
bei dem die im Betrieb erzeugt Strahlung die Halbleitersäulen (2) nur über den Basisbereich (27) in Richtung weg von den Spitzen (28) verlässt.

4. Halbleiterdisplay (10) nach einem der vorhergehenden Ansprüche,
bei dem die Halbleitersäulen (2) den Vergusskörper (5) an zwei einander gegenüberliegenden Hauptseiten (51, 52) des Vergusskörpers (5) überragen.

5. Halbleiterdisplay (10) nach einem der vorhergehenden Ansprüche,
bei dem die ersten Kontaktleisten (3) entlang von Zeilen an den Spitzen (28) verlaufen und die Halbleitersäulen (2) zumindest an den Spitzen (28) elektrisch kontaktiert sind.

6. Halbleiterdisplay (10) nach einem der vorhergehenden Ansprüche,
bei dem die Ausnehmungen (53) im Querschnitt gesehen eine von den Halbleitersäulen (2) verschiedene Grundform aufweisen.

7. Halbleiterdisplay (10) nach einem der vorhergehenden Ansprüche,
bei dem die zweiten Kontaktleisten (4) eine n-leitende Halbleiterschicht (41) umfassen, aus der heraus die Halbleitersäulen (2) gewachsen sind,
wobei die zweiten Kontaktleisten (4) als Spaltenkontakte gestaltet sind.

8. Halbleiterdisplay (10) nach dem vorhergehenden Anspruch,
bei dem an einer den Halbleitersäulen (2) abgewandte Seite der n-leitende Halbleiterschicht (41) mindestens ein Spiegel (42) zur Reflexion der im Betrieb erzeugten Strahlung angebracht ist,
wobei an dem oder an zumindest einem der Spiegel (42) eine elektrische Durchkontaktierung (43) in Richtung weg von den Halbleitersäulen (2) angebracht ist.

9. Halbleiterdisplay (10) nach einem der vorhergehenden Ansprüche,
ferner umfassend eine Maskenschicht (6) mit einer Vielzahl von Öffnungen (61),
wobei je eine der Halbleitersäulen (2) aus je einer Öffnung (61) gewachsen ist und die Öffnungen (6) je vollständig von den Halbleitersäulen (2) überdeckt sind, und
wobei die Maskenschicht (6) aus einem anorganischen Material ist und eine zusammenhängende Schicht mit einer Dicke von höchstens 10 nm bildet.

10. Halbleiterdisplay (10) nach einem der vorhergehenden Ansprüche,
bei dem die zweiten Kontaktleisten (4) mindestens eine transparente leitfähige Schicht (44) umfassen,
wobei die ersten Kontaktleisten (3) für die zu erzeugende Strahlung reflektierend gestaltet sind und die Bestromungshüllen (24) von den ersten Kontaktleisten (3) umfasst sind.

11. Halbleiterdisplay (10) nach dem vorhergehenden Anspruch,
bei dem die zweiten Kontaktleisten (4) zusätzlich mindestens eine metallische Stromschiene (46) umfassen,
wobei sich die Halbleitersäulen (2) entlang einer Hauptemissionsrichtung (M) jeweils zwischen der elektrisch zugeordneten transparenten leitfähigen Schicht (44) und der zugeordneten Stromschiene (46) befinden, und
wobei die Stromschiene (46) frei zugänglich ist.

12. Halbleiterdisplay (10) nach einem der vorhergehenden Ansprüche,
bei dem sich die Halbleitersäulen (2) an einem Aufwachssubstrat (20) befinden,
wobei die ersten und zweiten Kontaktleisten (3, 4) an der gleichen Seite des Aufwachssubstrats (20) angebracht sind wie die Halbleitersäulen (2).

13. Halbleiterdisplay (10) nach einem der vorhergehenden Ansprüche,
ferner umfassend elektrische Kontaktflächen (35, 45) zur externen elektrischen Kontaktierung der ersten und zweiten Kontaktleisten (3, 4),
wobei sich die Kontaktflächen (35, 45) in Draufsicht gesehen neben einem durch die Halbleitersäulen (2) gebildeten Abstrahlfeld (12) befinden, und
wobei alle Kontaktflächen (35, 45) an der gleichen Seite der Halbleitersäulen angebracht sind, sodass das Halbleiterdisplay (10) oberflächenmontierbar ist.

14. Halbleiterdisplay (10) nach dem vorhergehenden Anspruch, bei dem die elektrischen Kontaktflächen (35, 45) in Draufsicht gesehen eine größere Breite aufweisen als die zugehörigen ersten und/oder zweiten Kontaktleisten (3, 4).

15. Halbleiterdisplay (10) nach einem der vorhergehenden Ansprüche,
bei dem die Ausnehmungen (53) formgleich zu den Halbleitersäulen (2) gestaltet sind und die Ausnehmungen zu mindestens 70 % von den Halbleitersäulen (2) ausgefüllt sind, wobei der Vergusskörper (5) stellenweise direkt an die Bestromungshüllen (24) grenzt.

## Claims

1. Semiconductor display (10), having
- a multiplicity of semiconductor pillars (2), and
- first and second electrical contact strips (3, 4), and
- at least one potting body (5) which is non-transmissive for the radiation to be generated,
wherein
- the semiconductor pillars (2) each comprise a semiconductor core (21) of a first conductivity type and a semiconductor shell (23) of a second conductivity type different to the first, as well as an intervening active layer (22) for radiation generation,
- the semiconductor pillars (2) each comprise an energization shell (24) which is applied onto the respective semiconductor shell (23) for energization, and
- the semiconductor pillars (2) or small groups (29) of semiconductor pillars (2) are driveable independently of one another by means of the first and second electrical contact strips (3, 4), and the small groups (29) each comprise at most 25 of the semiconductor pillars (2), and
- the at least 10⁴ AlInGaN-based semiconductor pillars (2) are located in cutouts (53) of the potting body (5).

2. Semiconductor display (10) according to the preceding claim, wherein
- at least 10⁶ of the semiconductor pillars (2) are applied in the cutouts (53) of the potting body (5),
- an average diameter of the semiconductor pillars (2) lies between 40 nm and 5 µm inclusive,
- a ratio of an average height of the semiconductor pillars (2) and the average diameter lies between 0.5 and 3 inclusive,
- the semiconductor pillars (2) are hexagonal and are grown from a base region (27) and comprise a pyramidal tip (28) opposite the base region (27),
- the active layer (22) extends continuously over side surfaces (26) and the tip (28),
- the first contact strips (3) extend perpendicularly to the second contact strips (4) as seen in plan view, and
- the small groups (29) of semiconductor pillars (2) each comprise at most 16 of the semiconductor pillars (2).

3. Semiconductor display (10) according to either of the preceding claims,
wherein the radiation generated during operation leaves the semiconductor pillars (2) only through the base region (27) in the direction away from the tips (28).

4. Semiconductor display (10) according to any of the preceding claims,
wherein the semiconductor pillars (2) protrude from the potting body (5) on two mutually opposite main sides (51, 52) of the potting body (5).

5. Semiconductor display (10) according to any of the preceding claims,
wherein the first contact strips (3) extend along rows at the tips (28), and the semiconductor pillars (2) are electrically contacted at least at the tips (28).

6. Semiconductor display (10) according to any of the preceding claims,
wherein the cutouts (53) have a different basic shape than the semiconductor pillars (2), as seen in cross section.

7. Semiconductor display (10) according to any of the preceding claims,
wherein the second contact strips (4) comprise an n-conducting semiconductor layer (41), from which the semiconductor pillars (2) are grown,
the second contact strips (4) being configured as column contacts.

8. Semiconductor display (10) according to the preceding claim,
wherein at least one mirror (42) for reflection of the radiation generated during operation is applied on a side of the n-conducting semiconductor layer (41) facing away from the semiconductor pillars (2),
an electrical through-contact (43) in the direction away from the semiconductor pillars (2) being applied on the or on at least one of the mirrors (42).

9. Semiconductor display (10) according to any of the preceding claims,
furthermore comprising a mask layer (6) having a multiplicity of openings (61),
each of the semiconductor pillars (2) being grown from a respective opening (61) and the openings (6) each being fully covered by the semiconductor pillars (2), and
the mask layer (6) being made of an inorganic material and forming a continuous layer with a thickness of at most 10 nm.

10. Semiconductor display (10) according to any of the preceding claims,
wherein the second contact strips (4) comprise at least one transparent conductive layer (44),
the first contact strips (3) being configured to be reflective for the radiation to be generated and the energization shells (24) being encompassed by the first contact strips (3).

11. Semiconductor display (10) according to the preceding claim,
wherein the second contact strips (4) additionally comprise at least one metal busbar (46),
the semiconductor pillars (2) being located along a principal emission direction (M) respectively between the electrically assigned transparent conductive layer (44) and the assigned busbar (46), and
the busbar (46) being freely accessible.

12. Semiconductor display (10) according to any of the preceding claims,
wherein the semiconductor pillars (2) are located on a growth substrate (20),
the first and second contact strips (3, 4) being applied on the same side of the growth substrate (20) as the semiconductor pillars (2).

13. Semiconductor display (10) according to any of the preceding claims,
furthermore comprising electrical contact pads (35, 45) for external electrical contacting of the first and second contact strips (3, 4),
the contact pads (35, 45) being located next to an emission field (12) formed by the semiconductor pillars (2) as seen in plan view, and
all the contact pads (35, 45) being applied on the same side of the semiconductor pillars, so that the semiconductor display (10) is surface-mountable.

14. Semiconductor display (10) according to the preceding claim,
wherein the electrical contact pads (35, 45) have a greater width than the associated first and/or second contact strips (3, 4) as seen in plan view.

15. Semiconductor display (10) according to any of the preceding claims,
wherein the cutouts (53) are configured with the same shape as the semiconductor pillars (2), and the cutouts are filled to at least 70% by the semiconductor pillars (2),
the potting body (5) directly adjoining the energization shells (24) in places.

## Revendications

1. Affichage à semi-conducteur (10) comprenant
- une pluralité de colonnes à semi-conducteur (2) et
- des premières et deuxièmes réglettes enfichables électriques (3, 4) et
- au moins un corps de masse (5) opaque au rayonnement à produire, dans lequel
- les colonnes à semi-conducteur (2) comprennent chacune le noyau à semi-conducteur (21) d'un premier type de conductivité et la couverture semi-conductive (23) d'un deuxième type de conductivité différent du premier ainsi qu'une couche (22) active de production du rayonnement intercalée entre eux,
- les colonnes à semi-conducteur (2) comprennent chacune une couverture d'alimentation (24) installée pour l'alimentation sur la couverture semi-conductive (23) respective, et
- les colonnes à semi-conducteur (2), ou des petits ensembles (29) de colonnes à semi-conducteur (2) peuvent être amorcées par les premières et deuxièmes réglettes de contact électriques (3, 4) indépendamment les unes des autres et les petits ensembles (29) comprennent chacun tout au plus 25 des colonnes à semi-conducteur (2), et
- les au moins 10⁴ colonnes à semi-conducteur (2) à base d'AlInGaN se trouvent dans des enfoncements (53) du corps de masse (5).

2. Affichage à semi-conducteur (10) selon la revendication précédente,
dans lequel
- au moins 10⁶ des colonnes à semi-conducteur (2) sont installées dans les enfoncements (53) du corps de masse (5),
- le diamètre moyen des colonnes à semi-conducteur (2) se situe entre en ce compris 40 nm et 5 µm,
- le rapport d'une hauteur moyenne des colonnes à semi-conducteur (2) et du diamètre moyen se situant entre en ce compris 0,5 et 3,
- les colonnes à semi-conducteur (2) étant hexagonales et se dressant d'une zone de base (27) et présentant également une pointe (28) pyramidale vis-à-vis de la zone de base (27),
- la couche active (22) s'étendant de bout en bout sur les surfaces latérales (26) et la pointe (28),
- les premières réglettes de contact (3) passant, vue du dessus, à la perpendiculaire des deuxièmes réglettes de contact (4), et
- les petits ensembles (29) de colonnes à semi-conducteur (2) comprenant chacun tout au plus 16 des colonnes à semi-conducteur (2).

3. Affichage à semi-conducteur (10) selon l'une des revendications précédentes,
dans lequel le rayonnement produit pendant le fonctionnement ne quitte les colonnes à semi-conducteur (2) que par la zone de base (27) en s'éloignant des pointes (28).

4. Affichage à semi-conducteur (10) selon l'une des revendications précédentes,
dans lequel les colonnes à semi-conducteur (2) dépassent du corps de masse (5) sur deux côtés principaux (51, 52) du corps de masse (5) vis-à-vis l'un de l'autre.

5. Affichage à semi-conducteur (10) selon l'une des revendications précédentes,
dans lequel les premières réglettes de contact (3) passent le long de lignes sur les pointes (28) et les colonnes à semi-conducteur (2) sont sous contact électrique au moins sur les pointes (28).

6. Affichage à semi-conducteur (10) selon l'une des revendications précédentes,
dans lequel les enfoncements (53), vus en coupe, présentent une forme fondamentale qui diffère des colonnes à semi-conducteur (2).

7. Affichage à semi-conducteur (10) selon l'une des revendications précédentes,
dans lequel les deuxièmes réglettes de contact (4) comprennent une couche à semi-conducteur n-conductive (41) d'où croissent les colonnes à semi-conducteur (2),
les deuxièmes réglettes de contact (4) étant réalisées en tant que contacts à fente.

8. Affichage à semi-conducteur (10) selon la revendication précédente,
dans lequel sur un côté tournant le dos aux colonnes à semi-conducteur (2) de la couche à semi-conducteur (41) n-conductive, se trouve au moins un miroir (42) destiné à la réflexion du rayonnement produit pendant le fonctionnement,
une connexion transversale (43) électrique se trouvant sur le miroir (42) ou sur au moins l'un des miroirs (42) dans une direction s'éloignant des colonnes à semi-conducteur (2).

9. Affichage à semi-conducteur (10) selon l'une des revendications précédentes,
comprenant en outre une couche de masquage (6) comprenant une pluralité d'orifices (61),
chacune des colonnes à semi-conducteur (2) ayant crû de chaque fois un orifice (61) et les orifices (6) étant recouverts chacun intégralement par les colonnes à semi-conducteur (2), et
la couche de masquage (6) étant constituée d'une matière inorganique et formant une couche continue d'une épaisseur de tout au plus 10 nm.

10. Affichage à semi-conducteur (10) selon l'une des revendications précédentes,
dans lequel les deuxièmes réglettes de contact (4) comprennent au moins une couche conductive (44) transparente,
les premières réglettes de contact (3) servant au rayonnement à produire étant réalisées réfléchissantes et les couvertures d'alimentation (24) étant enveloppées par les premières réglettes de contact (3).

11. Affichage à semi-conducteur (10) selon la revendication précédente, dans lequel les deuxièmes réglettes de contact (4) comprennent en outre au moins un rail de courant (46) métallique, les colonnes à semi-conducteur (2) se trouvant le long d'une direction d'émission principale (M) à chaque fois entre la couche conductive (44) transparente électriquement dépendante et le rail de courant (46) subordonné, et
le rail de courant (46) étant librement accessible.

12. Affichage à semi-conducteur (10) selon l'une des revendications précédentes,
dans lequel les colonnes à semi-conducteur (2) se trouvent sur un substrat de croissance (20),
les premières et deuxièmes réglettes de contact (3, 4) se trouvant sur le même côté du substrat de croissance (20) que les colonnes à semi-conducteur (2).

13. Affichage à semi-conducteur (10) selon l'une des revendications précédentes,
comprenant en outre des surfaces de contact électriques (35, 45) pour la mise en contact électrique externe des premières et deuxièmes réglettes de contact (3, 4),
les surfaces de contact (35, 45), vues du dessus, se trouvant en outre à côté d'un champ rayonnant (12) formé par les colonnes à semi-conducteur (2), et
toutes les surfaces de contact (35, 45) se trouvant sur le même côté des colonnes à semi-conducteur, de sorte que l'affichage à semi-conducteur (10) peut être assemblé en surface.

14. Affichage à semi-conducteur (10) selon la revendication précédente, dans lequel les surfaces de contact électriques (35, 45), vues du dessus, présentent une largeur plus grande que les premières et/ou deuxièmes réglettes de contact (3, 4) respectives.

15. Affichage à semi-conducteur (10) selon l'une des revendications précédentes,
dans lequel les enfoncements (53) sont réalisés de la même forme que les colonnes à semi-conducteur (2) et les enfoncements sont remplis jusqu'à au moins 70% par les colonnes à semi-conducteur (2), le corps de masse (5) jouxtant par endroits directement les couvertures d'alimentation (24).
